(19) Europäisches Patentamt
European Patent Office
Office européen des brevets

(11) **EP 4 391 767 A1**

(12) # EUROPEAN PATENT APPLICATION


(43) Date of publication:
**26.06.2024 Bulletin 2024/26**

(21) Application number: **23204413.1**

(22) Date of filing: **18.10.2023**

(51) International Patent Classification (IPC):
***H10K 50/13*** *(2023.01)* *H10K 101/00* *(2023.01)*
*H10K 101/30* *(2023.01)* *H10K 85/60* *(2023.01)*

(52) Cooperative Patent Classification (CPC):
**H10K 50/13;** H10K 85/626; H10K 85/6572; H10K 2101/10; H10K 2101/30; H10K 2101/40; H10K 2101/90

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.12.2022 KR 20220182109**



(71) Applicant: **LG Display Co., Ltd.**
**Seoul 07336 (KR)**

(72) Inventors:
- **LEE, Sun-Hee**
  **10845 Paju-si (KR)**
- **YUN, Hui-Kun**
  **10845 Paju-si (KR)**
- **LEE, Woo-Young**
  **10845 Paju-si (KR)**
- **JO, Sung-Min**
  **10845 Paju-si (KR)**

(74) Representative: **Ter Meer Steinmeister & Partner Patentanwälte mbB**
**Nymphenburger Straße 4**
**80335 München (DE)**


(54) **ORGANIC LIGHT EMITTING DIODE AND ORGANIC LIGHT EMITTING DEVICE**


(57) An organic light emitting diode (OLED) and an organic light emitting device comprising the OLED (*e.g.,* a display device or a lighting device) are described. An emissive layer disposed between two electrodes includes a blue emitting material layer and a red emitting material layer disposed adjacently to the blue emitting material layer, where a first host in the blue emitting material layer and a second host in the red emitting material layer have controlled energy levels. As red and blue luminous efficiencies are controlled in balance, stable blue luminous efficiency and beneficial red luminous lifespan can be implemented.


**FIG. 3**

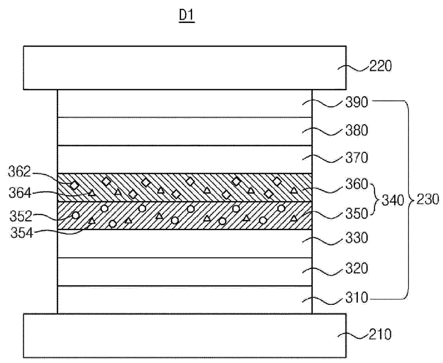


EP 4 391 767 A1

**Description**

## BACKGROUND

### Technical Field

The present invention relates to an organic light emitting diode (OLED), preferably an OLED with improved luminous efficiency and/or luminous lifespan, as well as to an organic light emitting device (*e.g.,* a display device or a lighting device) including the OLED.

### Description of the Related Art

Flat panel display devices including an organic light emitting diode (OLED) have certain advantages over a liquid crystal display device (LCD). For instance, the OLED can be formed as a thin organic film less than 2000 Å, and the electrode configurations can implement unidirectional or bidirectional images. Also, the OLED can be formed on a flexible transparent substrate such as a plastic substrate so that a flexible or a foldable display device can easily be manufactured using the OLED. In addition, the OLED can be driven at a lower voltage and the OLED has higher color purity compared to the LCD.

However, there remains a need to develop OLEDs and devices thereof that have improved luminous efficiency and luminous lifespan. Since fluorescent materials use only singlet excitons in the luminous process, there is an issue with low luminous efficiency. Meanwhile, phosphorescent materials can show high luminous efficiency since they use triplet exciton as well as singlet excitons in the luminous process. But, examples of such phosphorescent material include metal complexes, which can have a short luminous lifespan, which can be too short for commercial use. As such, there remains a need to develop an OLED with sufficient luminous efficiency, luminous lifespan and color purity.

## SUMMARY OF THE INVENTION

Embodiments of the present invention are directed to an organic light emitting diode and an organic light emitting device that address one or more of the limitations and disadvantages of the related art. An organic light-emitting diode and device thereof according to aspects of the present invention can operate at a low voltage, consume less power, render excellent colors, and/or can be used in a variety of applications. In an aspect, the OLED can also be formed on a flexible substrate, to provide a flexible or a foldable device. Further, the size of the OLED can be easily adjustable.

An object of the present invention is to provide an OLED with beneficial luminous efficiency and luminous lifespan, as well as an organic light emitting device including the OLED.

Additional features and aspects will be set forth in the description that follows, and in part will be apparent from the description, or can be learned by practice of the disclosed concepts provided herein. Other features and aspects of the disclosed concept can be realized and attained by the structure particularly pointed out in the written description, or derivable therefrom, and the claims hereof as well as the appended drawings.

To achieve these and other advantages and in accordance with objects of the invention, as embodied and broadly described herein, in one aspect, the present invention provides an organic light emitting diode that comprises a first electrode; a second electrode facing the first electrode; and an emissive layer disposed between the first electrode and the second electrode, and comprising at least one emitting material layer, wherein the at least one emitting material layer comprises a blue emitting material layer comprising a first host; and a red emitting material layer disposed between the blue emitting material layer and the second electrode, and comprising a second host, wherein a highest occupied molecular orbital energy (HOMO) energy level of the first host and a HOMO energy level of the second host satisfy the following relationship in Equation (1):

$$-0.5\ \mathrm{eV} \leq \mathrm{HOMO}^{H1} - \mathrm{HOMO}^{H2} < 0\ \mathrm{eV} \qquad (1)$$

wherein, in Equation (1), $\mathrm{HOMO}^{H1}$ indicates a HOMO energy level of the first host and $\mathrm{HOMO}^{H2}$ indicates a HOMO energy level of the second host.

In one embodiment, the HOMO energy level of the first host and the HOMO energy level of the second host can satisfy the following relationship in Equation (2):

$$-0.5\ \mathrm{eV} \leq \mathrm{HOMO}^{H1} - \mathrm{HOMO}^{H2} \leq -0.3\ \mathrm{eV} \qquad (2)$$

wherein, in Equation (2), $HOMO^{H1}$ indicates a HOMO energy level of the first host and $HOMO^{H2}$ indicates a HOMO energy level of the second host.

In a further embodiment, the first host can comprise an organic compound having the following structure of Chemical Formula 1:

[Chemical Formula 1]

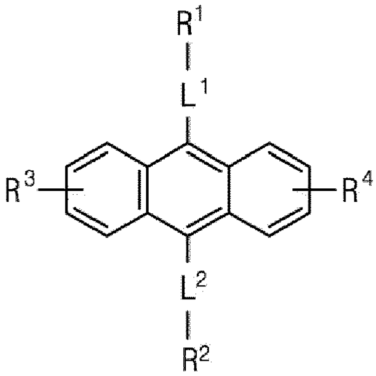

wherein, in Chemical Formula 1,

each of $R^1$ and $R^2$ is independently an unsubstituted or substituted $C_6$-$C_{30}$ aryl group or an unsubstituted or substituted $C_3$-$C_{30}$ hetero aryl group;

each of $R^3$ and $R^4$ is independently hydrogen, an unsubstituted or substituted $C_1$-$C_{20}$ alkyl group, an unsubstituted or substituted $C_6$-$C_{30}$ aryl group or an unsubstituted or substituted $C_3$-$C_{30}$ hetero aryl group; and

each of $L^1$ and $L^2$ is independently a single bond, an unsubstituted or substituted $C_6$-$C_{30}$ arylene group or an unsubstituted or substituted $C_3$-$C_{30}$ hetero arylene group.

In an embodiment of the invention, the second host can comprise an organic compound having the following structure of Chemical Formula 3:

[Chemical Formula 3]

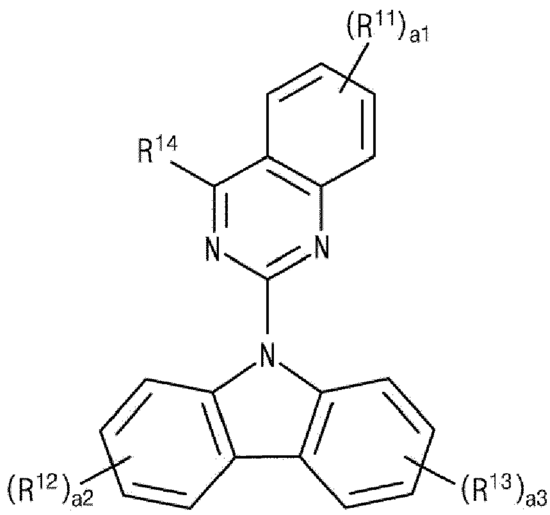

wherein, in Chemical Formula 3,

$R^{11}$ is an unsubstituted or substituted $C_6$-$C_{30}$ aryl group or an unsubstituted or substituted $C_3$-$C_{30}$ hetero aryl group, where each $R^{11}$ is identical to or different from each other when a1 is 2, 3 or 4;

each of $R^{12}$ and $R^{13}$ is independently an unsubstituted or substituted $C_6$-$C_{30}$ aryl group or an unsubstituted or substituted $C_3$-$C_{30}$ hetero aryl group, where each $R^{12}$ is identical to or different from each other when a2 is 2, 3 or

4, each $R^{13}$ is identical to or different from each other when a3 is 2, 3 or 4, and where at least one of $R^{12}$ and $R^{13}$ includes an unsubstituted or substituted $C_{10}$-$C_{30}$ fused hetero aryl group, or
optionally,
two adjacent $R^{12}$ when a2 is 2, 3 or 4, and/or
two adjacent $R^{13}$ when a3 is 2, 3 or 4
can be further linked together to form an unsubstituted or substituted $C_6$-$C_{10}$ aromatic ring;
$R^{14}$ is hydrogen, an unsubstituted or substituted $C_1$-$C_{20}$ alkyl group, an unsubstituted or substituted $C_6$-$C_{30}$ aryl group or an unsubstituted or substituted $C_3$-$C_{30}$ hetero aryl group; and
each of a1, a2 and a3 is independently 0, 1, 2, 3 or 4, where at least one of a1, a2 and a3 is not 0.

In a further aspect, it is provided an organic light emitting diode, comprising: a first electrode; a second electrode facing the first electrode; and an emissive layer disposed between the first and second electrode, and comprising at least one emitting material layer, wherein each of the at least one emitting material layer comprises: a blue emitting material layer comprising a first host; and a red emitting material layer disposed between the blue emitting material layer and the second electrode, and comprising a second host, wherein the first host comprises an organic compound having the following structure of Chemical Formula 1 as described herein, and wherein the second host comprises an organic compound having the following structure of Chemical Formula 3 as described herein.

In an embodiment of all aspects of the invention, the first host can be selected from the group consisting of 9,10-di(naphthalen-2-yl)anthracene (ADN), 2-methyl-9,10-bis(naphthalen-2-yl)anthracene (MADN), 2-tert-Butyl-9,10-di(naphthen-2-yl)anthracene (TBADN), 9,10-di(naphthalen-2-yl)-2-phenylanthracene (PADN), 9,10-di(1-naphthyl)anthracene, 9-(naphthalene-1-yl)-10-(naphthalene-2-yl)anthracene, 9-(2-napthyl)-10-[4-(1-naphthyl)phenyl]anthracene, 9-(1-napthyl)-10-[4-(2-naphthyl)phenyl]anthracene, 9-phenyl-10-(p-tolyl)anthracene (PTA), 9-(1-naphthyl)-10-(p-tolyl)anthracene (1-NTA), 9-(2-naphthyl)-10-(p-tolyl)anthracene (2-NTA), 2-(3-(10-phenylanthracen-9-yl)-phenyl)dibenzo[b,d]furan (m-PPDF), 2-(4-(10-phenylanthracen-9-yl)phenyl)dibenzo[b,d]furan (p-PPDF) and combinations thereof; and the second host can be at least one of the organic compounds corresponding to RH-1 to RH-28, as described herein.

In one embodiment, the emissive layer can comprise a first emitting part disposed between the first electrode and the second electrode; a second emitting part disposed between the first emitting part and the second electrode; a third emitting part disposed between the second emitting part and the second electrode; a fourth emitting part disposed between the third emitting part and the second electrode; a first charge generation layer disposed between the first emitting part and the second emitting part; a second charge generation layer disposed between the second emitting part and the third emitting part; and a third charge generation layer disposed between the third emitting part and the fourth emitting part, an one of the first emitting part, the second emitting part, the third emitting part and the fourth emitting part can comprise the blue emitting material layer and the red emitting material layer.

For example, the first emitting part can comprise the blue emitting material layer and the red emitting material layer.

In another aspect, the present invention provides an organic light emitting diode that comprises a first electrode; a second electrode facing the first electrode; and an emissive layer disposed between the first electrode and the second electrode, and comprising at least one emitting material layer, wherein the at least one emitting material layer comprises a blue emitting material layer comprising a first host; and a red emitting material layer disposed between the blue emitting material layer and the second electrode, and comprising a second host, wherein the first host comprises the organic compound having the structure of Chemical Formula 1, and the second host comprises the organic compound having the structure of Chemical Formula 3.

The HOMO energy level of the first host and the HOMO energy level of the second host can satisfy the relationships in Equation (1) or Equation (2).

In yet another aspect, the present invention provides an organic light emitting device, for example, an organic light emitting display device or an organic light emitting illumination device that comprises a substrate and the organic light emitting diode over the substrate.

In one or more embodiments, the OLED comprises the blue emitting material layer and the red emitting material layer disposed sequentially contacted to each other between two electrodes. As an example, a difference between the HOMO energy level (*i.e.,* $HOMO^{H1}$) of the first host and the HOMO energy level *(i.e.,* $HOMO^{H2}$) of the second host can be equal to or less than about 0.5 eV, for example, equal to or less than about 0.48 eV, 0.47 eV, 0.45 eV, 0.43 eV, 0.40 eV, 0.38 eV, 0.37 eV, 0.35 eV, 0.33 eV, 0.30 eV, 0.28 eV, 0.27 eV, 0.25 eV, 0.23 eV, 0.20 eV, 0.18 eV, 0.17 eV, 0.15 eV, 0.13 eV, or 0.10 eV. In another aspect, the difference between the HOMO energy level of the first host and the HOMO energy level of the second host can be more than 0 eV, for example, equal to or less than about 0.10 eV, 0.13 eV, 0.15 eV, 0.17 eV, 0.18 eV, 0.20 eV, 0.23 eV, 0.25 eV, 0.27 eV, 0.28 eV, 0.30 eV, 0.33 eV, 0.35 eV, 0.37 eV, 0.38 eV, 0.40 eV, 0.43 eV, 0.45 eV, 0.47 eV, or 0.48 eV..

Holes transported from the hole transport layer and electrons transported from the electron transport layer meet uniformly within the entire area of the emitting material layer comprising the blue emitting material layer and the red

emitting material layer to generate excitons. As the exciton recombination zone is generated within the emitting material layer, it is possible to maintain stable blue luminous efficiency.

As the excitons are not lost outside of the emitting material layer, it is possible to minimize the amount of the non-emitting excitons. The excitons are not quenched as non-emission by triplet-triplet annihilation (TTA) and/or triplet-polaron annihilation (TPA). As the exciton recombination zone is generated at an interface between the blue emitting material layer and the red emitting material layer, it is possible to suppress the generations of non-emitting excitons in the red emitting material layer, and to minimize the degradation of the luminous material caused by non-emitting excitons in the red emitting material layer.

In addition, it is possible to prevent excessive holes from leaking toward the red emitting material layer and/or the electron transport layer disposed adjacently to the red emitting material layer from the blue emitting material layer with relatively lower HOMO energy level. As the exciton quenching at an interface between the emitting material layer and the electron transport layer minimizes, the driving voltage of the OLED cannot be raised.

Beneficial and stable red luminous lifespan can be secured with maintaining stably blue luminous efficiency. It is possible to realize an OLED and an organic light emitting device that can secure stable red luminous efficiency with maintaining the blue luminous efficiency and the red luminous efficiency in balance.

It is to be understood that both the foregoing general description and the following detailed description are merely by way of example and are intended to provide further explanation of the inventive concepts as claimed.

## BRIEF DESCRIPTION OF THE DRAWINGS

The accompanying drawings, which are included to provide a further understanding of the invention, are incorporated in and constitute a part of this application, illustrate embodiments of the invention and together with the description serve to explain principles of the invention.

FIG. 1 illustrates a schematic circuit diagram of an organic light emitting display device according to one or more embodiments of the present invention.

FIG. 2 illustrates a cross-sectional view of an organic light emitting display device as an example of an organic light emitting device in accordance with one or more embodiments of the present invention.

FIG. 3 illustrates a cross-sectional view of an organic light emitting diode having a single emitting part in accordance with one or more embodiments of the present invention.

FIG. 4 illustrates a schematic diagram showing energy levels of hosts and charge transporting materials in a comparative example organic light emitting diode where a red emitting material layer is disposed adjacently to a hole transport layer and a blue emitting material layer is disposed adjacently to an electron transport layer.

FIG. 5 illustrates a schematic diagram showing energy levels of hosts and charge transporting materials and charge control layer in an organic light emitting diode in accordance with one embodiment where a blue emitting material layer is disposed adjacently to a hole transport layer and a red emitting material layer is disposed adjacently to an electron transport layer.

FIG. 6 illustrates a cross-sectional view of an organic light emitting display device in accordance with one or more embodiments of the present invention.

FIG. 7 illustrates a cross-sectional view of an organic light emitting diode having a tandem structure of multiple emitting parts in accordance with one or more embodiments of the present invention.

FIG. 8 illustrates measurement results showing electroluminescence (EL) spectra of an OLED fabricated in Example and Comparative Example.

FIG. 9 illustrates measurement result showing luminous lifespan of an OLED fabricated in Example and Comparative Example.

FIG. 10 illustrates measurement results showing EL spectra of an OLED fabricated in another Example and other Comparative Examples.

FIGS. 11 and 12 illustrate measurement results showing red luminous lifespan and blue luminous lifespan in an OLED fabricated in another Example and other Comparative Examples.

## DETAILED DESCRIPTION OF THE EMBODIMENTS

Reference will now be made in detail to aspects of the invention, examples of which are illustrated in the accompanying drawings. Wherever possible, the same reference numbers will be used throughout the drawings to refer to the same or like parts. In the following description, when a detailed description of well-known functions or configurations related to this document is determined to unnecessarily cloud a gist of the inventive concept, the detailed description thereof will be or can be omitted. The progression of processing steps and/or operations described is an example; however, the sequence of steps and/or operations is not limited to that set forth herein and can be changed as is known

in the art, with the exception of steps and/or operations necessarily occurring in a particular order. Names of the respective elements used in the following explanations are selected only for convenience of writing the specification and can be thus different from those used in actual products. Further, all the components of each organic light emitting diode (OLED) and each organic light emitting device (e.g., display device, illumination device, etc.) using the OLED according to all embodiments of the present invention are operatively coupled and configured.

The present invention relates to an organic light emitting diode and/or an organic light emitting device that includes a charge control layer with controlled hole mobility and/or energy level disposed between a red emitting material layer and a blue emitting material layer, that red luminous efficiency and blue luminous efficiency can be maintained in balance, and that can maximize luminous lifespan.

As an example, in one or more embodiments of the present invention, the emissive layer can be applied into an organic light emitting diode with a single emitting unit in a red pixel region and/or a blue pixel region. Alternatively, the emissive layer can be applied into an organic light emitting diode where multiple emitting parts are stacked to form a tandem-structure. The organic light emitting diode can be applied to an organic light emitting device such as an organic light emitting display device or an organic light emitting illumination device.

FIG. 1 illustrates a schematic circuit diagram of an organic light emitting display device in accordance with one or more embodiments of the present invention.

As illustrated in FIG. 1, a gate line GL, a data line DL and a power line PL, each of which crosses each other to define a pixel region P, are provided in an organic light emitting display device 100. A switching thin film transistor Ts, a driving thin film transistor Td, a storage capacitor Cst and an organic light emitting diode D are disposed within the pixel region P. The pixel region P can include a red (R) pixel region, a green (G) pixel region and a blue (B) pixel region. The organic light emitting display device 100 includes a plurality of such pixel regions P which can be arranged in a matrix configuration or other configurations. Further, each pixel region P can include one or more subpixels. However, embodiments of the present invention are not limited to such examples.

The switching thin film transistor Ts is connected to the gate line GL and the data line DL. The driving thin film transistor Td and the storage capacitor Cst are connected between the switching thin film transistor Ts and the power line PL. The organic light emitting diode D is connected to the driving thin film transistor Td. When the switching thin film transistor Ts is turned on by a gate signal applied to the gate line GL, a data signal applied to the data line DL is applied to a gate electrode of the driving thin film transistor Td and one electrode of the storage capacitor Cst through the switching thin film transistor Ts.

The driving thin film transistor Td is turned on by the data signal applied to a gate electrode 130 (FIG. 2) so that a current proportional to the data signal is supplied from the power line PL to the organic light emitting diode D through the driving thin film transistor Td. Then the organic light emitting diode D emits light having a luminance proportional to the current flowing through the driving thin film transistor Td. In this case, the storage capacitor Cst is charged with a voltage proportional to the data signal so that the voltage of the gate electrode in the driving thin film transistor Td is kept constant during one frame. Therefore, the organic light emitting display device can display a desired image.

FIG. 2 illustrates a schematic cross-sectional view of an organic light emitting display device in accordance with an embodiment of the present invention. The pixel circuit configuration of FIG. 1 can be used in the display device of FIG. 2 or other figures of the present application.

As illustrated in FIG. 2, the organic light emitting display device 100 includes a substrate 102, a thin-film transistor Tr on the substrate 102, and an organic light emitting diode D connected to the thin film transistor Tr. As an example, the substrate 102 can include a red pixel region, a green pixel region and a blue pixel region and an organic light emitting diode D can be located in each pixel region. Each of the organic light emitting diodes D emitting red, green and blue light, respectively, is located correspondingly in the red pixel region, the green pixel region and the blue pixel region. For example, the organic light emitting diode D can be disposed in the blue pixel region and/or the red pixel region.

The substrate 102 can include, but is not limited to, glass, thin flexible material and/or polymer plastics. For example, the flexible material can be selected from the group, but is not limited to, polyimide (PI), polyethersulfone (PES), polyethylenenaphthalate (PEN), polyethylene terephthalate (PET), polycarbonate (PC) and/or combinations thereof. The substrate 102, on which the thin film transistor Tr and the organic light emitting diode D are arranged, forms an array substrate.

A buffer layer 106 can be disposed on the substrate 102. The thin film transistor Tr can be disposed on the buffer layer 106. In certain embodiments, the buffer layer 106 can be omitted.

A semiconductor layer 110 is disposed on the buffer layer 106. In one embodiment, the semiconductor layer 110 can include, but is not limited to, oxide semiconductor materials. In this case, a light-shield pattern can be disposed under the semiconductor layer 110, and the light-shield pattern can prevent light from being incident toward the semiconductor layer 110, thereby, preventing or reducing the semiconductor layer 110 from being degraded by the light. Alternatively, the semiconductor layer 110 can include polycrystalline silicon. In this case, opposite edges of the semiconductor layer 110 can be doped with impurities.

A gate insulating layer 120 including an insulating material is disposed on the semiconductor layer 110. The

gate insulating layer 120 can include, but is not limited to, an inorganic insulating material such as silicon oxide ($SiO_x$, wherein $0 < x \leq 2$) or silicon nitride ($SiN_x$, wherein $0 < x \leq 2$).

A gate electrode 130 made of a conductive material such as a metal is disposed on the gate insulating layer 120 so as to correspond to a center of the semiconductor layer 110. While the gate insulating layer 120 is disposed on the entire area of the substrate 102 as shown in FIG. 2, the gate insulating layer 120 can be patterned identically as the gate electrode 130.

An interlayer insulating layer 140 including an insulating material is disposed on the gate electrode 130 and covers an entire surface of the substrate 102. The interlayer insulating layer 140 can include, but is not limited to, an inorganic insulating material such as silicon oxide ($SiO_x$, wherein $0 < x \leq 2$) or silicon nitride ($SiN_x$, wherein $0 < x \leq 2$), or an organic insulating material such as benzocyclobutene or photo-acryl.

The interlayer insulating layer 140 has first and second semiconductor layer contact holes 142 and 144 that expose or do not cover a portion of the surface nearer to the opposing ends than to a center of the semiconductor layer 110. The first and second semiconductor layer contact holes 142 and 144 are disposed on opposite sides of the gate electrode 130 and spaced apart from the gate electrode 130. The first and second semiconductor layer contact holes 142 and 144 are formed within the gate insulating layer 120 in FIG. 2. Alternatively, in certain embodiments, the first and second semiconductor layer contact holes 142 and 144 can be formed only within the interlayer insulating layer 140 when the gate insulating layer 120 is patterned identically as the gate electrode 130.

A source electrode 152 and a drain electrode 154, which are made of conductive material such as a metal, are disposed on the interlayer insulating layer 140. The source electrode 152 and the drain electrode 154 are spaced apart from each other on opposing sides of the gate electrode 130, and contact both sides of the semiconductor layer 110 through the first and second semiconductor layer contact holes 142 and 144, respectively.

The semiconductor layer 110, the gate electrode 130, the source electrode 152 and the drain electrode 154 constitute the thin film transistor Tr, which acts as a driving element. The thin film transistor Tr in FIG. 2 has a coplanar structure in which the gate electrode 130, the source electrode 152 and the drain electrode 154 are disposed on the semiconductor layer 110. Alternatively, the thin film transistor Tr can have an inverted staggered structure in which a gate electrode is disposed under a semiconductor layer and a source and drain electrodes are disposed on the semiconductor layer. In this case, the semiconductor layer can include amorphous silicon. Here, the designation of the source and drain electrodes 152 and 154 can be switched with each other depending on the type and configuration of a transistor.

The gate line GL and the data line DL, which cross each other to define a pixel region P, and a switching element Ts, which is connected to the gate line GL and the data line DL, can be further formed in the pixel region P. The switching element Ts is connected to the thin film transistor Tr, which is a driving element. In addition, the power line PL is spaced apart in parallel from the gate line GL or the data line DL. The thin film transistor Tr can further include a storage capacitor Cst configured to constantly keep a voltage of the gate electrode 130 for one frame.

A passivation layer 160 is disposed on the source and drain electrodes 152 and 154. The passivation layer 160 covers the thin film transistor Tr on the entire substrate 102. The passivation layer 160 has a flat top surface and a drain contact hole (or a contact hole) 162 that exposes or does not cover the drain electrode 154 of the thin film transistor Tr. While the drain contact hole 162 is disposed on the second semiconductor layer contact hole 144, it can be spaced apart from the second semiconductor layer contact hole 144.

The organic light emitting diode (OLED) D includes a first electrode 210 that is disposed on the passivation layer 160 and connected to the drain electrode 154 of the thin film transistor Tr. The OLED D further includes an emissive layer 230 and a second electrode 220 each of which is disposed sequentially on the first electrode 210.

The first electrode 210 is disposed in each pixel region P. The first electrode 210 can be an anode and include conductive material having relatively high work function value. For example, the first electrode 210 can include a transparent conductive oxide (TCO). For example, the first electrode 210 can include, but is not limited to, indium tin oxide (ITO), indium zinc oxide (IZO), indium tin zinc oxide (ITZO), tin oxide (SnO), zinc oxide (ZnO), indium cerium oxide (ICO), aluminum doped zinc oxide (AZO), and/or combinations thereof.

In one embodiment, when the organic light emitting display device 100 is a bottom-emission type, the first electrode 210 can have a single-layered structure of the TCO. Alternatively, when the organic light emitting display device 100 is a top-emission type, a reflective electrode or a reflective layer can be disposed under the first electrode 210. For example, the reflective electrode or the reflective layer can include, but is not limited to, silver (Ag) or aluminum-palladium-copper (APC) alloy. In the OLED D of the top-emission type, the first electrode 210 can have a triple-layered structure of ITO/Ag/ITO or ITO/APC/ITO.

In addition, a bank layer 164 is disposed on the passivation layer 160 in order to cover edges of the first electrode 210. The bank layer 164 exposes or does not cover a center of the first electrode 210 corresponding to each pixel region. In certain embodiments, the bank layer 164 can be omitted.

The emissive layer 230 is disposed on the first electrode 210. In one embodiment, the emissive layer 230 can have a single-layered structure of an emitting material layer (EML). Alternatively, the emissive layer 230 can have a multiple-layered structure of a hole injection layer (HIL), a hole transport layer (HTL), an electron blocking layer (EBL),

an EML, a hole blocking layer (HBL), an electron transport layer (ETL), an electron injection layer (EIL) and/or a charge generation layer (CGL) (FIGS. 3 and 7).

In one embodiment, the emissive layer 230 can have a single emitting part. Alternatively, the emissive layer 230 can have multiple emitting parts to form a tandem structure. For example, the emissive layer 230 can be applied to an organic light emitting diode having a single emissive layer disposed in each of the red pixel region, the green pixel region and the blue pixel region, respectively. Alternatively, the emissive layer 230 can be applied to an organic light emitting diode of a tandem structure stacked multiple emitting parts. The emissive layer 230 can includes a charge control layer including material with controlled hole mobility and/or energy level.

The emissive layer 230 can include a blue emitting material layer and a red emitting material layer each of which includes a host with a controlled energy level.

The second electrode 220 is disposed on the substrate 102 above which the emissive layer 230 is disposed. The second electrode 220 can be disposed on the entire display area. The second electrode 220 can include a conductive material with a relatively low work function value compared to the first electrode 210, and can be a cathode providing electrons. For example, the second electrode 220 can include highly reflective material such as aluminum (Al), magnesium (Mg), calcium (Ca), silver (Ag), alloy thereof and/or combinations thereof such as aluminum-magnesium alloy (Al-Mg). When the organic light emitting display device 100 is a top-emission type, the second electrode 220 is thin so as to have light-transmissive (semi-transmissive) property.

In addition, an encapsulation film 170 can be disposed on the second electrode 220 in order to prevent or reduce outer moisture from penetrating into the OLED D. The encapsulation film 170 can have, but is not limited to, a laminated structure of a first inorganic insulating film 172, an organic insulating film 174 and a second inorganic insulating film 176. In certain embodiments, the encapsulation film 170 can be omitted.

A polarizing plate can be attached onto the encapsulation film 170 to reduce reflection of external light. For example, the polarizing plate can be a circular polarizing plate. When the organic light emitting display device 100 is a bottom-emission type, the polarizing plate can be disposed under the substrate 102. Alternatively, when the organic light emitting display device 100 is a top-emission type, the polarizing plate can be disposed on the encapsulation film 170. In addition, a cover window can be attached to the encapsulation film 170 or the polarizing plate. In this case, the substrate 102 and the cover window can have a flexible property, thus the organic light emitting display device 100 can be a flexible display device.

In one embodiment, a color filter pattern can be disposed between the substrate 102 and the OLED D, or on the OLED D. The color filter pattern can include a red color filter and/or a blue color filter, and the organic light emitting device 100 can be disposed at the red pixel region and/or the blue pixel region.

The OLED D is described in more detail. FIG. 3 illustrates a schematic cross-sectional view of an organic light emitting diode having a single emitting part in accordance with an embodiment of the present invention. For instance, FIG. 3 shows an example (OLED D1) of the OLED D in FIGS. 1 and 2.

As illustrated in FIG. 3, the organic light emitting diode (OLED) D1 in accordance with an embodiment includes first and second electrodes 210 and 220 facing each other and an emissive layer 230 disposed between the first and second electrodes 210 and 220. The organic light emitting display device 100 includes a red pixel region, a green pixel region and a blue pixel region, and the OLED D1 can be disposed in the red pixel region and/or the blue pixel region.

In an embodiment, the emissive layer 230 includes an emitting material layer (EML) 340 disposed between the first and second electrodes 210 and 220. The emissive layer 230 can include at least one of a hole transport layer (HTL) 320 disposed between the first electrode 210 and the EML 340 and an electron transport layer (ETL) 380 disposed between the second electrode 220 and the EML 340. In certain embodiments, the emissive layer 230 can further include at least one of a hole injection layer (HIL) 310 disposed between the first electrode 210 and the HTL 320 and an electron injection layer (EIL) 390 disposed between the second electrode 220 and the ETL 380. Alternatively or additionally, the emissive layer 230 can further include a first exciton blocking layer, *i.e.* an electron blocking layer (EBL) 330 disposed between the HTL 320 and the EML 340 and/or a second exciton blocking layer, *i.e.* a hole blocking layer (HBL) 370 disposed between the EML 340 and the ETL 380.

The first electrode 210 can be an anode that provides a hole into the EML 340. The first electrode 210 can include a conductive material having a relatively high work function value, for example, a transparent conductive oxide (TCO). In an embodiment, the first electrode 210 can include, but is not limited to, ITO, IZO, ITZO, SnO, ZnO, ICO, AZO, and/or combinations thereof.

The second electrode 220 can be a cathode that provides an electron into the EML 340. The second electrode 220 can include a conductive material having a relatively low work function value. For example, the second electrode 220 can include highly reflective material such as Al, Mg, Ca, Ag, alloy thereof and/or combinations thereof such as aluminum-magnesium alloy (Al-Mg).

The EML 340 includes a blue emitting material layer (B-EML) 350 and a red emitting material layer (R-EML) 360 disposed sequentially between the HTL 320, or the EBL 330, and the ETL 380, or the HBL 370. The B-EML 350 disposed adjacently to the HTL 320 or the EBL 330 compared to the R-EMI, 360 includes a first host (blue host) 352

and a blue emitter (blue dopant) 354. The R-EMI, 360 disposed adjacently to the ETL 380 or the HBL 370 includes a second host (red host) 362 and a red emitter (red dopant) 364. The substantial light emission in the B-EML 350 and the R-EMI, 360 is occurred at the blue emitter 354 and the red emitter 364.

The first host 352 can include at least one of a P-type blue host and an N-type blue host. The second host 362 can include at least one of a P-type red host and an N-type red host.

In one embodiment, the B-EML 350 is disposed adjacently to the first electrode 210 or the HTL 320, and the R-EMI, 360 is disposed adjacently to the second electrode 220 or the ETL 380. It is possible to realize the OLED D1 with beneficial luminous properties by controlling the energy levels of at least one of the luminous materials in the B-EML 350 and the R-EMI, 360.

FIG. 4 illustrates a schematic diagram showing energy levels of hosts and charge transporting materials in a comparative example organic light emitting diode where a red emitting material layer is disposed adjacently to a hole transport layer and a blue emitting material layer is disposed adjacently to an electron transport layer.

As illustrated in FIG. 4, in the blue-red junction device where a red emitting material layer R-EMI, is disposed adjacently to the hole transport layer HTL and a blue emitting material layer B-EML is disposed adjacently to the electron transport layer ETL, the B-EML generally uses a host with beneficial electron transportation properties. Since the holes and electrons generate mainly excitons in the R-EML, the emission in the B-EML with strong electron transportation properties is little generated. In this case, red emission is occurred mainly and blue emission is little occurred in the conventional diode, there is a disadvantage for acting as the red-blue junction device.

In addition, excessive holes not forming excitons in the R-EMI, are leaked toward to the B-EML and/or the ETL, so that exciton quenching in the B-EML and the ETL is caused thereby. The quenched as non-emissive excitons applies stresses on the luminous material in the B-EML, the electron transporting material in the ETL and the luminous material in the R-EML, and therefore, can be a factor degrading those luminous materials and the charge transporting materials. Therefore, the luminous lifespan of the red and blue luminous materials can be lowered.

FIG. 5 illustrates a schematic diagram showing energy levels of hosts and charge transporting materials and charge control layer in an organic light emitting diode in accordance with one embodiment where a blue emitting material layer is disposed adjacently to a hole transport layer and a red emitting material layer is disposed adjacently to an electron transport layer. As illustrated in FIGS. 3 and 5, when the B-EML 350 is disposed adjacently to the HTL 320 and the R-EMI, 360 is disposed adjacently to the ETL 380, a difference between a highest occupied molecular orbital (HOMO) energy level of the R-EMI, 360 and a HOMO energy level of the ETL 380 becomes relatively large. Holes are not leaked toward the ETL 380, and holes and electrons injected into the B-EML 350 and the R-EMI, 360 are recombined to generate excitons. As the exciton recombination zone is generated within the entire area of the EML 340 including the B-EML 350 and the R-EMI, 360, the blue light luminous efficiency can be maintained and reinforced stably. It is possible to minimize the amount of degradation of the luminous material and the charge transporting material by non-emitting excitons by preventing the non-emitting excitons, and therefore, the blue luminous lifespan and/or the red luminous lifespan can be improved.

As the excitons are not lost outside of the EML 340, it is possible to minimize the amount of the non-emitting excitons. The excitons are not quenched as non-emission by triplet-triplet annihilation (TTA) and/or triplet-polaron annihilation (TPA). In addition, the degradation of the luminous material caused by the non-emitting excitons in the B-EML 350 and the R-EMI, 360 can be minimized as the exciton recombination zone is generated uniformly within the entire area of the B-EML 350 and the R-EMI, 360.

Therefore, it is possible to secure the red luminous lifetime stably with maintaining stable blue luminous efficiency. It is possible to realize the OLED D1 and the organic light emitting display device 100 that can secure stable red luminous lifespan with maintaining stable blue luminous efficiency and red luminous efficiency in balance by applying the structure of the emissive layer 230.

In one embodiment, the first host 352 in the B-EML 350 can have a HOMO energy level lower (deeper) than a HOMO energy level of the second host 362 in the R-EMI, 360. As an example, the HOMO energy level of the first host 352 and the HOMO energy level of the second host 362 can satisfy the following relationship in Equation (1):

$$-0.5\ \text{eV} \leq \text{HOMO}^{H1} - \text{HOMO}^{H2} < 0\ \text{eV} \qquad (1)$$

wherein, in Equation (1), $\text{HOMO}^{H1}$ indicates a HOMO energy level of the first host and $\text{HOMO}^{H2}$ indicates a HOMO energy level of the second host.

When the HOMO energy level of the first host 352 and the HOMO energy level of the second host 362 satisfy the relationship in Equation (1), exciton recombination can be generated efficiently within the B-EML 350 and the R-EMI, 360 as holes transfers efficiently to the R-EMI, 360 from the B-EML 350. On the contrary, when the HOMO energy level of the first host 352 and the HOMO energy level of the second host 362 do not satisfy the relationship in Equation (1), it can be difficult to realize stable blue luminous efficiency and/or the red luminous efficiency can be too be lowered.

In one embodiment, the HOMO energy level of the first host 352 and the HOMO energy level of the second host 362 can satisfy the following relationship in Equation (2):

$$-0.5 \text{ eV} \leq HOMO^{H1} - HOMO^{H2} \leq -0.3 \text{ eV} \quad (2)$$

wherein, in Equation (2), $HOMO^{H1}$ indicates a HOMO energy level of the first host and $HOMO^{H2}$ indicates a HOMO energy level of the second host.

In one embodiment, the first host 352 can include an anthracene-containing organic compound. As used herein, the term "anthracene-based organic compound" comprises anthracene-containing organic compounds, or derivatives thereof. As an example, the first host 352 can include, but is not limited to, an anthracene-containing organic compound having the following structure of Chemical Formula 1:

[Chemical Formula 1]

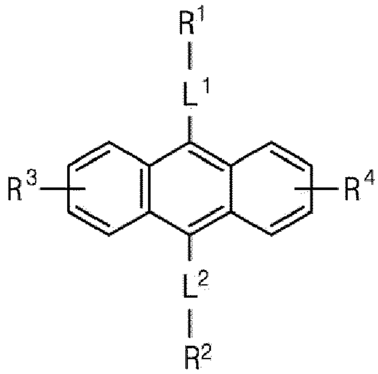

wherein, in Chemical Formula 1,

each of $R^1$ and $R^2$ is independently an unsubstituted or substituted $C_6$-$C_{30}$ aryl group or an unsubstituted or substituted $C_3$-$C_{30}$ hetero aryl group;

each of $R^3$ and $R^4$ is independently hydrogen, an unsubstituted or substituted $C_1$-$C_{20}$ alkyl group, an unsubstituted or substituted $C_6$-$C_{30}$ aryl group or an unsubstituted or substituted $C_3$-$C_{30}$ hetero aryl group; and

each of $L^1$ and $L^2$ is independently a single bond, an unsubstituted or substituted $C_6$-$C_{30}$ arylene group or an unsubstituted or substituted $C_3$-$C_{30}$ hetero arylene group.

As used herein, the term "unsubstituted" means that hydrogen is directly linked to a carbon atom. "Hydrogen", as used herein, can refer to protium, deuterium and tritium.

As used herein, "substituted" means that the hydrogen is replaced with a substituent. The substituent can comprise, but is not limited to, an unsubstituted or halogen-substituted $C_1$-$C_{20}$ alkyl group, an unsubstituted or halogen-substituted $C_1$-$C_{20}$ alkoxy, halogen, a cyano group, a hydroxyl group, a carboxylic group, a carbonyl group, an amino group, a $C_1$-$C_{10}$ alkyl amino group, a $C_6$-$C_{30}$ aryl amino group, a $C_3$-$C_{30}$ hetero aryl amino group, a nitro group, a hydrazyl group, a sulfonate group, a $C_1$-$C_{10}$ alkyl silyl group, a $C_1$-$C_{10}$ alkoxy silyl group, a $C_3$-$C_{20}$ cyclo alkyl silyl group, a $C_6$-$C_{30}$ aryl silyl group, a $C_3$-$C_{30}$ hetero aryl silyl group, an unsubstituted or substituted $C_6$-$C_{30}$ aryl group, an unsubstituted or substituted $C_3$-$C_{30}$ hetero aryl group.

As used herein, the term "hetero" in terms such as "a hetero aryl group", and "a hetero arylene group" and the likes means that at least one carbon atom, for example 1 to 5 carbons atoms, constituting an aliphatic chain, an alicyclic group or ring or an aromatic group or ring is substituted with at least one hetero atom selected from the group consisting of N, O, S and P.

The aryl group can independently include, but is not limited to, an unfused or fused aryl group such as phenyl, biphenyl, terphenyl, naphthyl, anthracenyl, pentalenyl, indenyl, indeno-indenyl, heptalenyl, biphenylenyl, indacenyl, phenalenyl, phenanthrenyl, benzo-phenanthrenyl, dibenzo-phenanthrenyl, azulenyl, pyrenyl, fluoranthenyl, triphenylenyl, chrysenyl, tetraphenylenyl, tetracenyl, pleiadenyl, picenyl, pentaphenylenyl, pentacenyl, fluorenyl, indeno-fluorenyl or spiro-fluorenyl.

The hetero aryl group can independently include, but is not limited to, an unfused or fused hetero aryl group such as pyrrolyl, pyridinyl, pyrimidinyl, pyrazinyl, pyridazinyl, triazinyl, tetrazinyl, imidazolyl, pyrazolyl, indolyl, iso-indolyl, indazolyl, indolizinyl, pyrrolizinyl, carbazolyl, benzo-carbazolyl, dibenzo-carbazolyl, indolo-carbazolyl, indeno-carbazolyl,

benzofuro-carbazolyl, benzo-thieno-carbazolyl, carbolinyl, quinolinyl, iso-quinolinyl, phthlazinyl, quinoxalinyl, cinnolinyl, quinazolinyl, quinolizinyl, purinyl, benzo-quinolinyl, benzo-iso-quinolinyl, benzo-quinazolinyl, benzo-quinoxalinyl, acridinyl, phenazinyl, phenoxazinyl, phenothiazinyl, phenanthrolinyl, perimidinyl, phenanthridinyl, pteridinyl, naphthyridinyl, furanyl, pyranyl, oxazinyl, oxazolyl, oxadiazolyl, triazolyl, dioxinyl, benzo-furanyl, dibenzo-furanyl, thiopyranyl, xanthenyl, chromenyl, iso-chromenyl, thioazinyl, thiophenyl, benzo-thiophenyl, dibenzo-thiophenyl, difuro-pyrazinyl, benzofuro-dibenzo-furanyl, benzothieno-benzo-thiophenyl, benzothieno-dibenzo-thiophenyl, benzothieno-benzo-furanyl, benzothieno-dibenzo-furanyl, xanthene-linked spiro acridinyl, dihydroacridinyl substituted with at least one $C_1$-$C_{10}$ alkyl and N-substituted spiro fluorenyl.

As an example, each of the aryl group or the hetero aryl group can consist of one to four aromatic and/or hetero aromatic rings. When the number of the aromatic and/or hetero aromatic rings becomes more than four, conjugated structure within the whole molecule becomes too long, thus, the organometallic compound can have too narrow a difference. For example, each of the aryl group or the hetero aryl group can include independently, but is not limited to, phenyl, biphenyl, naphthyl, anthracenyl, pyrrolyl, triazinyl, imidazolyl, pyrazolyl, pyridinyl, pyrazinyl, pyrimidinyl, pyridazinyl, furanyl, benzo-furanyl, dibenzo-furanyl, thiophenyl, benzo-thiophenyl, dibenzo-thiophenyl, carbazolyl, acridinyl, carbolinyl, phenazinyl, phenoxazinyl, or phenothiazinyl.

As an example, each of the aromatic group or the hetero aromatic group can consist of one to three aromatic and/or hetero aromatic rings. When the number of the aromatic and/or hetero aromatic rings becomes more than four, conjugated structure within the whole molecule becomes too long, thus, the organometallic compound can have too narrow a difference. For example, each of the aryl group or the hetero aryl group can comprise independently, but is not limited to, phenyl, biphenyl, naphthyl, anthracenyl, pyrrolyl, triazinyl, imidazolyl, pyrazolyl, pyridinyl, pyrazinyl, pyrimidinyl, pyridazinyl, furanyl, benzo-furanyl, dibenzo-furanyl, thiophenyl, benzo-thiophenyl, dibenzo-thiophenyl, carbazolyl, acridinyl, carbolinyl, phenazinyl, phenoxazinyl, or phenothiazinyl

In one embodiment, each of the $C_1$-$C_{10}$ alkyl group, the $C_6$-$C_{30}$ aryl group and the $C_3$-$C_{30}$ hetero aryl group of $R^1$ to $R^4$ can be independently unsubstituted or further substituted with at least one of a $C_1$-$C_{10}$ alkyl group, $C_6$-$C_{30}$ aryl group and $C_3$-$C_{30}$ hetero aryl group.

For example, the first host 352 of the anthracene-containing organic compound can be selected from, but is not limited to, the group consisting of 9,10-di(naphthalen-2-yl)anthracene (ADN), 2-methyl-9,10-bis(naphthalen-2-yl)anthracene (MADN), 2-tert-Butyl-9,10-di(naphthen-2-yl)anthracene (TBADN), 9,10-di(naphthalen-2-yl)-2-phenylanthracene (PADN), 9,10-di(1-naphthyl)anthracene, 9-(naphthalene-1-yl)-10-(naphthalene-2-yl)anthracene, 9-(2-napthyl)-10-[4-(1-naphthyl)phenyl]anthracene, 9-(1-napthyl)-10-[4-(2-naphthyl)phenyl]anthracene, 9-phenyl-10-(p-tolyl)anthracene (PTA), 9-(1-naphthyl)-10-(p-tolyl)anthracene (1-NTA), 9-(2-naphthyl)-10-(p-tolyl)anthracene (2-NTA), 2-(3-(10-phenylanthracen-9-yl)-phenyl)dibenzo[b,d]furan (m-PPDF), 2-(4-(10-phenylanthracen-9-yl)phenyl)dibenzo[b,d]furan (p-PPDF) and combinations thereof.

A structure of some compounds among the first host 352 of the anthracene-containing organic compound is illustrated in the following Chemical Formula 2:

[Chemical Formula 2]

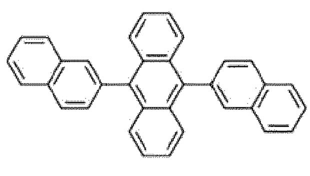

BH1

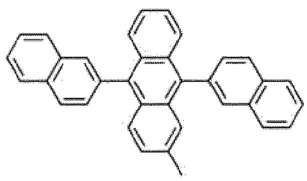

BH2

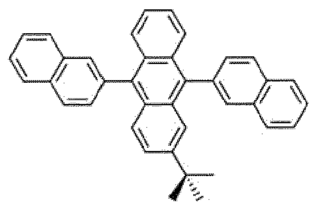

BH3

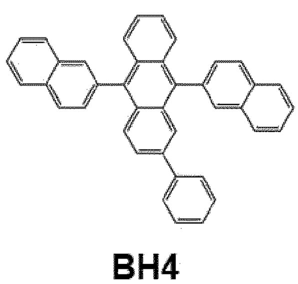

BH4

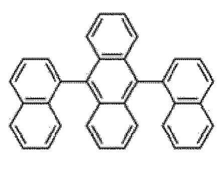

BH5

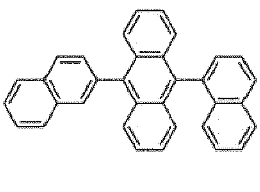

BH6

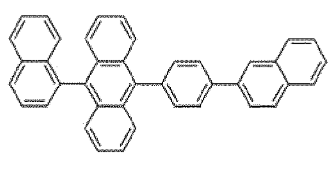

BH7

Each of the Compounds BH1, BH2, BH3, BH4, BH5, BH6 and BH7 is ADN (HOMO: - 5.8 eV, LUMO: -2.6 eV), MADN (HOMO: -5.5 eV, LUMO: -2.5 eV), TBADN (HOMO: -5.8 eV, LUMO: -2.9 eV), PADN, 9,10-di(1-naphthyl)anthracene, 9-(naphthalene-1-yl)-10-(naphthalene-2-yl)anthracene, 9-(2-naphthyl)-10-[4-(1-napthyl)phenyl]anthracene (HOMO: -6.7 eV, LUMO: - 3.0 eV).

The blue emitter 354 can include at least one of blue phosphorescent material, blue fluorescent material and blue delayed fluorescent material. As an example, the blue emitter 354 can include, but is not limited to, perylene, 4,4'-Bis[4-(di-p-tolylamino)styryl]biphenyl (DPAVBi), 4-(Di-p-tolylamino)-4-4'-[(di-p-tolylamino)styryl]stilbene (DPAVB), 4,4'-Bis[4-(diphenylamino)styryl]biphenyl (BDAVBi), 2,7-Bis(4-diphenylamino)styryl)-9,9-spirofluorene (spiro-DPVBi), [1,4-bis[2-[4-[N,N-di(p-tolyl)amino]phenyl]vinyl]benzene (DSB), 1,4-di-[4-(N,N-diphenyl)amino]styryl-benzene (DSA), 2,5,8,11-Tetra-tetr-butylperylene (TBPe), Bis((2-hydroxylphenyl)-pyridine)beryllium ($Bepp_2$), 9-(9-Phenylcarbazol-3-yl)-10-(naphthalen-1-yl)anthracene (PCAN), mer-Tris(1-phenyl-3-methylimidazolin-2-ylidene-C,C(2))'iridium(III) (mer-$Ir(pmi)_3$), fac- Tris(1 ,3-diphenyl-benzimidazolin-2-ylidene-C, C(2))' iridium(III) (fac-$Ir(dpbic)_3$), Bis(3,4,5-trifluoro-2-(2-pyridyl)phenyl-(2-carboxypyridyl))iridium(III) ($Ir(tfpd)_2pic$), tris(2-(4,6-difluorophenyl)pyridine)iridium(III) ($Ir(Fppy)_3$), Bis[2-(4,6-difluorophenyl)pyridinato-$C^2$,N](picolinato)iridium(III) (FIrpic), DABNA-1, DABNA-2, t-DABNA, v-DABNA and/or combinations thereof.

The contents of the first host 352 in the B-EML 350 can be between about 50 wt.% to about 99 wt.%, for example, about 95 wt.% to about 99 wt.%, and the contents of the blue emitter 354 in the B-EML 350 can be between about 1 wt.% to about 50 wt.%, for example, about 1 wt.% to about 5 wt.%, but is not limited thereto. When the B-EML 350 includes the P-type blue host and the N-type blue host, the P-type blue host and the N-type blue host can be mixed with, but is not limited to, a weight ratio of about 4:1 to about 1:4, for example, about 3:1 to about 1:3.

In one embodiment, the second host 362 can include a quinazoline-based organic compound. As used herein, the term "quinazoline-based organic compound" comprises quinazoline-containing organic compounds, or derivatives thereof. As an example, the second host 362 can include, but is not limited to, a quinazoline-containing organic compound having the following structure of Chemical Formula 3:

[Chemical Formula 3]

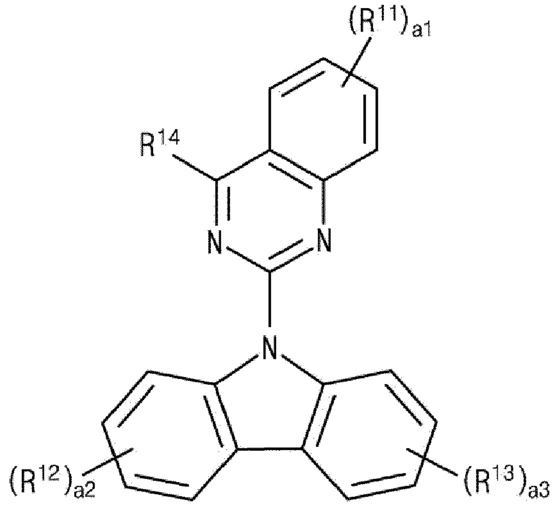

wherein, in Chemical Formula 3,

$R^{11}$ is an unsubstituted or substituted $C_6$-$C_{30}$ aryl group or an unsubstituted or substituted $C_3$-$C_{30}$ hetero aryl group, where each $R^{11}$ is identical to or different from each other when a1 is 2, 3 or 4;

each of $R^{12}$ and $R^{13}$ is independently an unsusubstituted or substituted $C_6$-$C_{30}$ aryl group or an unsubstituted or substituted $C_3$-$C_{30}$ hetero aryl group, where each $R^{12}$ is identical to or different from each other when a2 is 2, 3 or 4, each $R^{13}$ is identical to or different from each other when a3 is 2, 3 or 4, and where at least one of $R^{12}$ and $R^{13}$ includes an unsubstituted or substituted $C_{10}$-$C_{30}$ fused hetero aryl group, or

optionally,

two adjacent $R^{12}$ when a2 is 2, 3 or 4, and/or

two adjacent $R^{13}$ when a3 is 2, 3 or 4

can be further linked together to form an unsubstituted or substituted $C_6$-$C_{10}$ aromatic ring;

$R^{14}$ is hydrogen, an unsubstituted or substituted $C_1$-$C_{20}$ alkyl group, an unsubstituted or substituted $C_6$-$C_{30}$ aryl group or an unsubstituted or substituted $C_3$-$C_{30}$ hetero aryl group; andeach of a1, a2 and a3 is independently 0, 1,

2, 3 or 4, where at least one of a1, a2 and a3 is not 0.

In one embodiment, a1 can be 0, a2 can be 0 or two adjacent $R^{12}$ can be further linked together to form an unsubstituted or substituted benzene ring, $R^{13}$ can be selected from carbazolyl, benzo-carbazolyl, dibenzo-furanyl and dibenzo-thiophenyl each of which can be independently unsubstituted or substituted with at least one of phenyl, biphenyl, naphthyl and fluorenyl (e.g., 9,10-dimenthylhydrofluorenyl), and/or $R^{14}$ can include phenyl, biphenyl and naphthyl each of which can be independently unsubstituted or further substituted with phenyl.

For example, the second host 362 of the quinazoline-containing organic compound can be, but is not limited to, at least one of the following compounds of Chemical Formula 4:

[Chemical Formula 4]

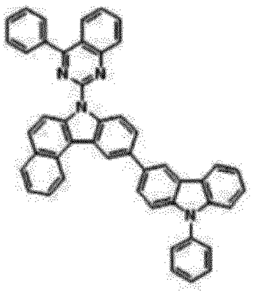

RH1

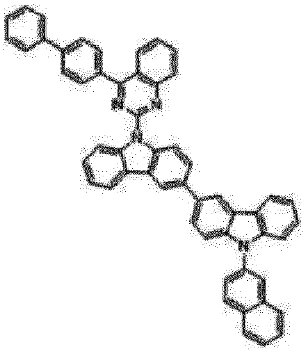

RH2

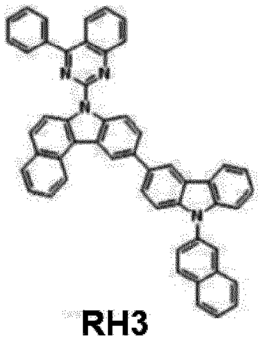

RH3

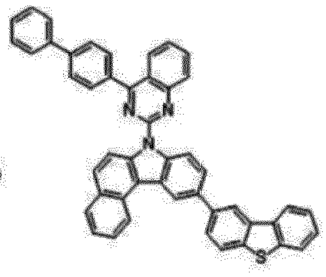

RH4

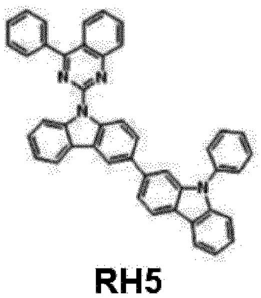

RH5

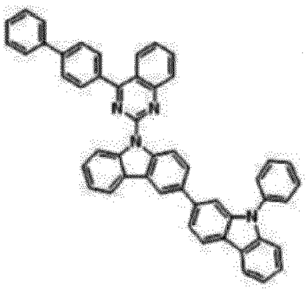

RH6

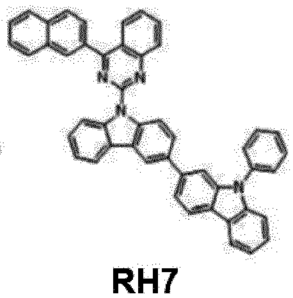

RH7

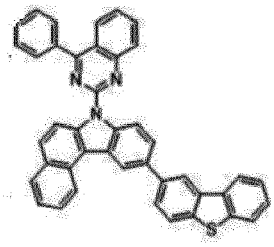

RH8

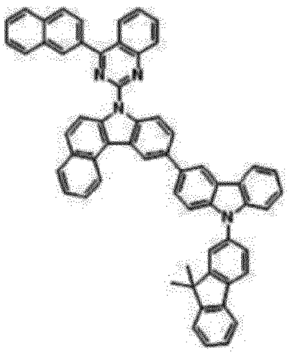

RH9

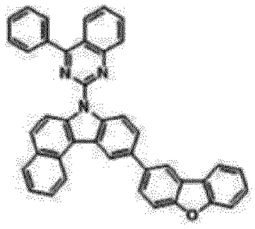

RH10

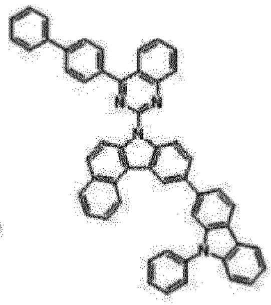

RH11

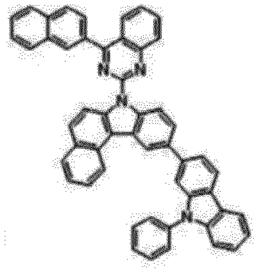

RH12

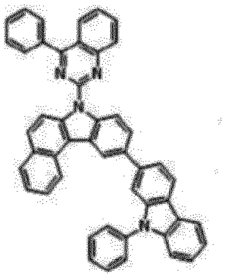

RH13

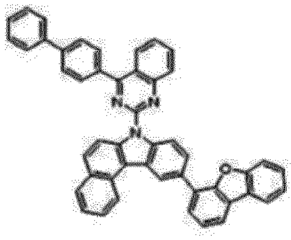

RH14

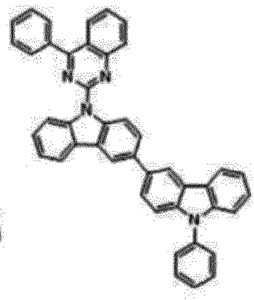

RH15

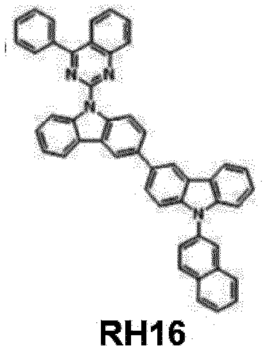

RH16

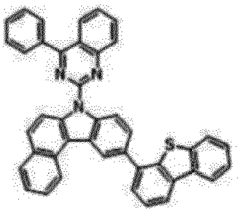

RH17

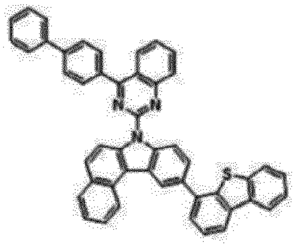

RH18

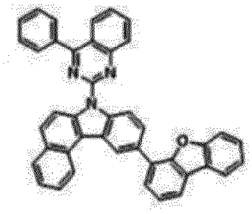

RH19

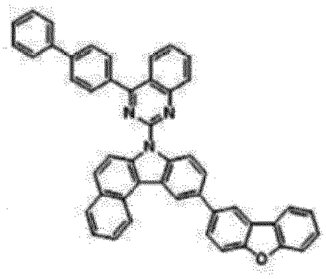

RH20

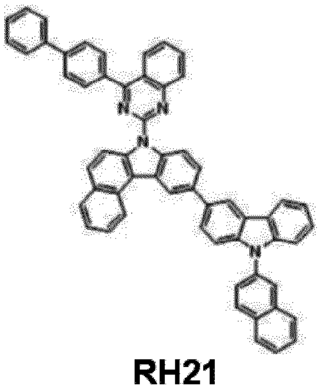

RH21

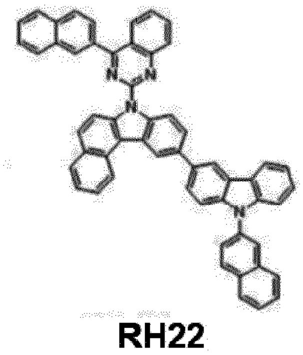

RH22

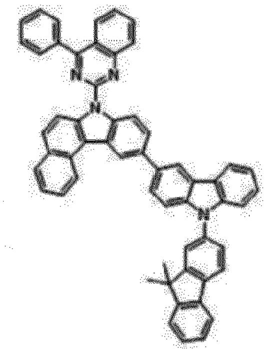

RH23

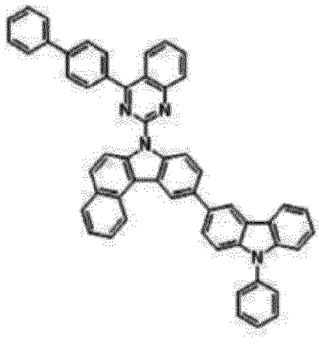

RH24

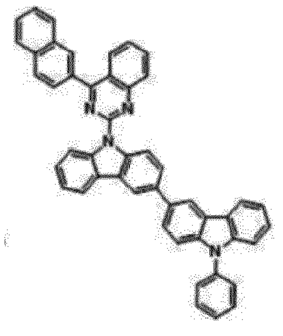

RH25

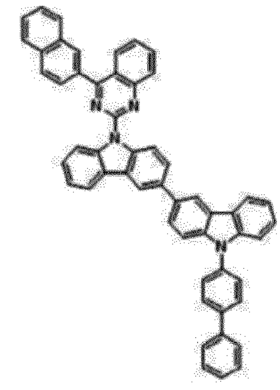

RH26

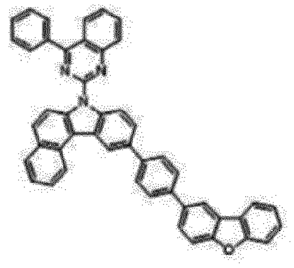

RH27

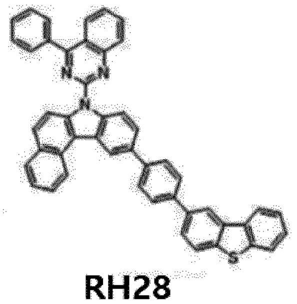

RH28

.

The red emitter 364 can include at least one of red phosphorescent material, red fluorescent material and red delayed fluorescent material. As an example, the red emitter 364 can include, but is not limited to, Bis[2-(4,6-dimethyl)phenylquinoline](2,2,6,6-tetramethylheptane-3,5-dionate)iridium(III), Bis[2-(4-n-hexylphenyl)quinoline](acetylacetonate)iridium(III) (Hex-Ir(phq)$_2$(acac)), Tris[2-(4-n-hexylphenyl)quinoline]iridium(III) (Hex-Ir(phq)$_3$), Tris[2-phenyl-4-methylquinoline]iridium(III) (Ir(Mphq)$_3$), Bis(2-phenylquinoline)(2,2,6,6-tetramethylheptene-3,5-dionate)iridium(III) (Ir(dpm)PQ$_2$), Tris(1-phenylisoquinoline)iridium(III) (Ir(piq)$_3$), Bis(phenylisoquinoline)(2,2,6,6-tetramethylheptene-3,5-dionate)iridium(III) (Ir(dpm)(piq)$_2$), Bis(1-phenylisoquinoline)(acetylacetonate)iridium(III) (Ir(piq)$_2$(acac)), Bis[(4-n-hexylphenyl)isoquinoline](acetylacetonate)iridium(III) (Hex-Ir(piq)$_2$(acac)), Tris[2-(4-n-hexylphenyl)quinoline]iridium(III) (Hex-Ir(piq)$_3$), Tris(2-(3-methylphenyl)-7-methyl-quinolato)iridium (Ir(dmpq)$_3$), Bis[2-(2-methylphenyl)-7-methylquinoline](acetylacetonate)iridium(III) (Ir(dmpq)$_2$(acac)), Bis[2-(3,5-dimethylphenyl)-4-methylquinoline](acetylacetonate)iridium(III) (Ir(mphmq)$_2$(acac)), Tris(dibenzoylmethane)mono(1,10-phenanthroline)europium(III) (Eu(dbm)$_3$(phen)) and/or combinations thereof.

The contents of the second host 362 in the R-EMI, 360 can be between about 50 wt.% to about 99 wt.%, for example, about 95 wt.% to about 98 wt.%, and the contents of the red emitter 364 in the R-EMI, 360 can be between about 1 wt.% to about 50 wt.%, for example, about 2 wt.% to about 5 wt.%, but is not limited thereto. When the R-EMI, 360 includes the P-type red host and the N-type red host, the P-type red host and the N-type red host can be mixed with, but is not limited to, a weight ratio of about 4:1 to about 1:4, for example, about 3:1 to about 1:3.

The HIL 310 is disposed between the first electrode 210 and the HTL 320 and can improve an interface property between the inorganic first electrode 210 and the organic HTL 320. In one embodiment, hole injecting material in the HIL 310 can include, but is not limited to, 4,4',4"-Tris(3-methylphenylamino)triphenylamine (MTDATA), 4,4',4"-Tris(N,N-diphenyl-amino)triphenylamine (NATA), 4,4',4"-Tris(N-(naphthalene-1-yl)-N-phenyl-amino)triphenylamine (1T-NATA), 4,4',4"-Tris(N-(naphthalene-2-yl)-N-phenyl-amino)triphenylamine (2T-NATA), Copper phthalocyanine (CuPc), Tris(4-carbazoyl-9-yl-phenyl)amine (TCTA), N,N'-Diphenyl-N,N'-bis(1-naphthyl)-1,1'-biphenyl-4,4"-diamine (NPB; NPD), N,N'-Bis{4-[bis(3-methylphenyl)amino]phenyl}-N,N'-diphenyl-4,4'-biphenyldiamine (DNTPD), 1,4,5,8,9,11-Hexaazatriphenylenehexacarbonitrile (Dipyrazino[2,3-f:2'3'-h]quinoxaline-2,3,6,7,10,11-hexacarbonitrile; HAT-CN), 2,3,5,6-Tetrafluoro-7,7,8,8-tetracyanoquinodimethane (F4-TCNQ), 1,3,4,5,7,8-hexafluoro-tetracyano-naphthoquinodimethane (F6-TCNNQ), 1,3,5-tris[4-(diphenylamino)phenyl]benzene (TDAPB), poly(3,4-ethylenedioxythiphene)polystyrene sulfonate (PEDOT/PSS), N-(biphenyl-4-yl)-9,9-dimethyl-N-(4-(9-phenyl-9H-carbazol-3-yl)phenyl)-9H-fluoren-2-amine, N,N'-diphenyl-N,N'-di[4-(N,N'-diphenyl-amino)phenyl]benzidine (NPNPB), $MgF_2$, $CaF_2$, the compound of the following Chemical Formula 5, and/or combinations thereof.

[Chemical Formula 5]

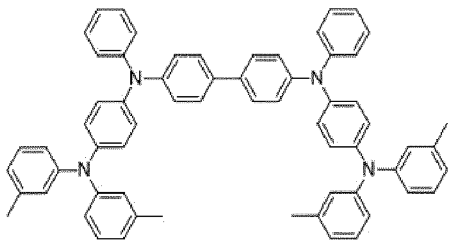

In another embodiment, the HIL 310 can include the hole transporting material described below doped with the above hole injecting material (e.g., HAT-CN, F4-TCNQ and/or F6-TCNNQ). In this case, the contents of the hole injecting material in the HIL 310 can be, but is not limited to, about 2 wt.% to about 15 wt.%. In certain embodiments, the HIL 310 can be omitted in compliance of the OLED D1 property.

The HTL 320 is disposed between the first electrode 210 and the EML 340. In one embodiment, the hole transporting material in the HTL 320 can include, but is not limited to, N,N'-Diphenyl-N,N'-bis(3-methylphenyl)-1,1'-biphenyl-4,4'-diamine (TPD), NPB(NPD), DNTPD, 4,4'-bis(N-carbazolyl)-1,1'-biphenyl (CBP), Poly[N,N' -bis(4-butylphenyl)-N,N' -bis(phenyl)-benzidine] (Poly-TPD), Poly[(9,9-dioctylfluorenyl-2,7-diyl)-co-(4,4'-(N-(4-sec-butylphenyl)diphenylamine))] (TFB), Di-[4-(N,N-di-p-tolyl-amino)-phenyl]cyclohexane (TAPC), 3,5-Di(9H-carbazol-9-yl)-N,N-diphenylaniline (DCDPA), N-(biphenyl-4-yl)-9,9-dimethyl-N-(4-(9-phenyl-9H-carbazol-3-yl)phenyl)-9H-fluoren-2-amine, N-(biphenyl-4-yl)-N-(4-(9-phenyl-9H-carbazol-3-yl)phenyl)biphenyl-4-amine, N-([1,1'-Biphenyl]-4-yl)-9,9-dimethyl-N-(4-(9-phenyl-9H-carbazol-3-yl)phenyl)-9H-fluoren-2-amine and/or combinations thereof.

The ETL 380 and the EII, 390 can be laminated sequentially between the EML 340 and the second electrode 220. An electron transporting material included in the ETL 380 has high electron moibity so as to provide electrons stably with the EML 340 by fast electron transportation.

In one embodiment, electron transporting material in the ETL 380 can include at least one of an oxadiazole-containing compound, a triazole-containing compound, a phenanthroline-containing compound, a benzoxazole-containing compound, a benzothiazole-containing compound, a benzimidazole-containing compound, a triazine-containing compound and/or combinations thereof.

For example, the electron transporting material in the ETL 380 can include, but is not limited to, tris-(8-hydroxyquinoline) aluminum ($Alq_3$), 2-biphenyl-4-yl-5-(4-t-butylphenyl)-1,3,4-oxadiazole (PBD), spiro-PBD, lithium quinolate (Liq), 2,2', 2"-(1,3,5-benzenetriyl)-tris(1-phenyl-1-H-benzimidazole) (TPBi), Bis(2-methyl-8-quinolinolato-N1,O8)-(1,1'-biphenyl-4-olato)aluminum (BAlq), 4,7-diphenyl-1,10-phenanthroline (Bphen), 2,9-Bis(naphthalene-2-yl)4,7-diphenyl-1,10-phenanthroline (NBphen), 2,9-Dimethyl-4,7-diphenyl-1,10-phenathroline (BCP), 3-(4-Biphenyl)-4-phenyl-5-tert-butylphenyl-1,2,4-triazole (TAZ), 4-(Naphthalen-1-yl)-3,5-diphenyl-4H-1,2,4-triazole (NTAZ), 1,3,5-Tri(p-pyrid-3-yl-phenyl)benzene (TpPyPB), 2,4,6-Tris(3'-(pyridin-3-yl)biphenyl-3-yl)1,3,5-triazine (TmPPPyTz), Poly[9,9-bis(3'-((N,N-dimethyl)-N-ethylammonium)-propyl)-2,7-fluorene]-alt-2,7-(9,9-dioctylfluorene) dibromide (PFNBr), tris(phenylquinoxaline) (TPQ), Diphenyl-4-triphenylsilyl-phenylphosphine oxide (TSPO1), 2-[4-(9,10-Di-2-naphthalen2-yl-2-anthracen-2-yl)phenyl]-1-phenyl-1H-benzimidazole (ZADN) and/or combinations thereof.

The EIL 390 is disposed between the second electrode 220 and the ETL 380, and can improve physical properties of the second electrode 220 and therefore, can enhance the lifespan of the OLED D1. In one embodiment, electron injecting material in the EII, 390 can include, but is not limited to, an alkali metal halide and/or an alkaline earth metal halide such as LiF, CsF, NaF, $BaF_2$ and the like, and/or an organometallic compound such as Liq, lithium benzoate, sodium stearate, and the like. In certain embodiment, the EIL 390 can be omitted.

In another embodiment, the EIL 390 can include the electron transporting material doped with alkali metal such as Li, Na, K and the likes and/or alkaline earth metal such as Mg, Ca and the likes. In this case, the contents of the alkali metal and/or the alkaline earth metal in the EIL 390 can be, but is not limited to, about 0.5 wt.% to about 10 wt.%.

When holes are transferred to the second electrode 220 via the EML 340, or electrons are transferred to the first electrode 210 via the EML 340, the OLED D1 can have short lifespan and reduced luminous efficiency. In order to prevent those phenomena, the OLED D1 in accordance with one embodiment can further include at least one exciton blocking layer disposed adjacently to the EML 340.

For example, the OLED D1 in accordance with one embodiment can further include the EBL 330 between the HTL 320 and the EML 340 so as to control and prevent electron transportation. As an example, electron blocking material in the EBL 330 can include, but is not limited to, TCTA, N-(biphenyl-4-yl)-9,9-dimethyl-N-(4-(9-phenyl-9H-carbazol-3-yl)phenyl)-9H-fluoren-2-amine, TAPC, MTDATA, 1,3-Bis(carbazol-9-yl)benzene (mCP), 3,3-Di(9H-carbazol-9-yl)biphenyl (mCBP), CuPc, DNTPD, TDABP, DCDPA, 2,8-bis(9-phenyl-9H-carbazol-3-yl)dibenzo[b,d]thiophene and/or combinations thereof.

In addition, the OLED D1 in accordance with one embodiment can further include the HBL 370 between the EML 340 and the ETL 380 so that holes cannot be transferred from the EML 340 to the ETL 380. In one embodiment, hole blocking material in the HBL 370 can include, but is not limited to, at least one of an oxadiazole-containing compound, a triazole-containing compound, a phenanthroline-containing compound, a benzoxazole-containing compound, a benzothiazole-containing compound, a benzimidazole-containing compound, and a triazine-containing compound.

For example, hole blocking material in the HBL 370 can include material having a relatively low HOMO energy level compared to the luminescent materials in EML 340. The hole blocking material in the HBL 370 can include, but is not limited to, BCP, BAlq, $Alq_3$, PBD, spiro-PBD, Liq, Bis-4,5-(3,5-di-3-pyridylphenyl)-2-methylpyrimidine (B3PYMPM), Bis[2-(diphenylphosphino)phenyl]ether oxide (DPEPO), 9-(6-(9H-carbazol-9-yl)pyridine-3-yl)-9H-3,9'-bicarbazole, TSPO1 and/or combinations thereof. In certain embodiments, each of the EBL 330 and/or the HBL 370 can be omitted.

The B-EML 350 is disposed adjacently to the HTL 320 and the R-EMI, 360 is disposed adjacently to the ETL 380. As the exciton recombination is generated within the EML 340, it is possible to maintain stable blue luminous efficiency. As degradations of the luminous material and the charge transporting materials are minimized by suppressing exciton quenching, it is possible to secure stable red luminous lifespan.

An organic light emitting display device and an organic light emitting diode with a single emitting unit emitting blue and red color lights is described in the above embodiment. In another embodiment, an organic light emitting display device can implement full-color including white color. As an example, FIG. 6 illustrates a schematic cross-sectional view of an organic light emitting display device in accordance with another embodiment of the present invention.

As illustrated in FIG. 6, an organic light emitting display device 400 includes a first substrate 402 that defines each of a red pixel region RP, a green pixel region GP and a blue pixel region BP, a second substrate 404 facing the first substrate 402, a thin film transistor Tr on the first substrate 402, an organic light emitting diode (OLED) D disposed between the first and second substrates 402 and 404 and emitting white (W) light and a color filter layer 480 disposed between the OLED D and the first substrate 402. The organic light emitting display device 400 can include a plurality of such pixel regions arranged in a matrix configuration or other suitable configurations.

Each of the first and second substrates 402 and 404 can include, but is not limited to, glass, flexible material and/or polymer plastics. For example, each of the first and second substrates 402 and 404 can be made of PI, PES, PEN, PET, PC and/or combinations thereof. The first substrate 402, on which a thin film transistor Tr and the OLED D are arranged, forms an array substrate. In certain embodiments, the second substrate 404 can be omitted.

A buffer layer 406 can be disposed on the first substrate 402. The thin film transistor Tr is disposed on the buffer layer 406 correspondingly to each of the red pixel region RP, the green pixel region GP and the blue pixel region BP. In certain embodiments, the buffer layer 406 can be omitted.

A semiconductor layer 410 is disposed on the buffer layer 406. The semiconductor layer 410 can be made of or include oxide semiconductor material or polycrystalline silicon.

A gate insulating layer 420 including an insulating material, for example, inorganic insulating material such as silicon oxide ($SiO_x$, wherein $0 < x \leq 2$) or silicon nitride ($SiN_x$, wherein $0 < x \leq 2$) is disposed on the semiconductor layer 410.

A gate electrode 430 made of a conductive material such as a metal is disposed over the gate insulating layer 420 so as to correspond to a center or middle area of the semiconductor layer 410. An interlayer insulating layer 440 including an insulating material, for example, inorganic insulating material such as $SiO_x$ or $SiN_x$, or an organic insulating material such as benzocyclobutene or photo-acryl, is disposed on the gate electrode 430.

The interlayer insulating layer 440 has first and second semiconductor layer contact holes 442 and 444 that expose or do not cover a portion of the surface nearer to the opposing ends than to a center of the semiconductor layer 410. The first and second semiconductor layer contact holes 442 and 444 are disposed on opposite sides of the gate electrode 430 with spacing apart from the gate electrode 430.

A source electrode 452 and a drain electrode 454, which are made of or include a conductive material such as a metal, are disposed on the interlayer insulating layer 440. The source electrode 452 and the drain electrode 454 are spaced apart from each other with respect to the gate electrode 430. The source electrode 452 and the drain electrode 454 contact both sides of the semiconductor layer 410 through the first and second semiconductor layer contact holes 442 and 444, respectively. The source and drain electrodes 452 and 454 can be switched with each other depending on the types of transistors and display structure used.

The semiconductor layer 410, the gate electrode 430, the source electrode 452 and the drain electrode 454 constitute the thin film transistor Tr, which acts as a driving element.

In some aspects, as shown in FIG. 1, the gate line GL and the data line DL, which cross each other to define the pixel region P, and a switching element Ts, which is connected to the gate line GL and the data line DL, can be further formed in the pixel region P. The switching element Ts is connected to the thin film transistor Tr, which is a driving element. In addition, the power line PL is spaced apart in parallel from the gate line GL or the data line DL, and the thin film transistor Tr can further include the storage capacitor Cst configured to constantly keep a voltage of the gate electrode 430 for one frame.

A passivation layer 460 is disposed on the source electrode 452 and the drain electrode 454 and covers the

thin film transistor Tr over the whole first substrate 402. The passivation layer 460 has a drain contact hole 462 that exposes or does not cover the drain electrode 454 of the thin film transistor Tr.

The OLED D is located on the passivation layer 460. The OLED D includes a first electrode 510 that is connected to the drain electrode 454 of the thin film transistor Tr, a second electrode 520 facing the first electrode 510 and an emissive layer 530 disposed between the first and second electrodes 510 and 520.

The first electrode 510 formed for each pixel region RP, GP or BP can be an anode and can include a conductive material having relatively high work function value. For example, the first electrode 510 can include, but is not limited to, ITO, IZO, ITZO, SnO, ZnO, ICO, AZO, and/or combinations thereof.

A bank layer 464 is disposed on the passivation layer 460 in order to cover edges of the first electrode 510. The bank layer 464 exposes or does not cover a center of the first electrode 510 corresponding to each of the red pixel region RP, the green pixel region GP and the blue pixel region BP. In certain embodiments, the bank layer 464 can be omitted.

An emissive layer 530 that can include multiple emitting parts is disposed on the first electrode 510. As illustrated in FIG. 7 as one example, the emissive layer 530 can include multiple emitting parts 600, 700, 800 and 900, and at least one charge generation layer 690, 790 and890. Each of the emitting parts 600, 700, 800 and 900 includes at least one emitting material layer and can further include a hole injection layer, a hole transport layer, an electron blocking layer, a hole blocking layer, an electron transport layer and/or an electron injection layer. FIG. 7 will be discussed in more detail later.

Referring back to FIG. 6, the second electrode 520 can be disposed on the first substrate 402 above which the emissive layer 530 can be disposed. The second electrode 520 can be disposed over a whole display area, can include a conductive material with a relatively low work function value compared to the first electrode 510, and can be a cathode. For example, the second electrode 520 can include, but is not limited to, highly reflective material such as Al, Mg, Ca, Ag, alloy thereof, and/or combinations thereof such as Al-Mg.

The color filter layer 480 is disposed between the first substrate 402 and the OLED D, for example, the interlayer insulating layer 440 and the passivation layer 460. The color filter layer 480 can include a red color filter pattern 482, a green color filter pattern 484 and a blue color filter pattern 486 each of which is disposed correspondingly to the red pixel region RP, the green pixel region GP and the blue pixel region BP, respectively.

In addition, an encapsulation film 470 can be disposed on the second electrode 520 in order to prevent or reduce outer moisture from penetrating into the OLED D. The encapsulation film 470 can have, but is not limited to, a laminated structure including a first inorganic insulating film, an organic insulating film and a second inorganic insulating film (e.g., film 170 in FIG. 2). In addition, a polarizing plate can be attached onto the second substrate 404 to reduce reflection of external light. For example, the polarizing plate can be a circular polarizing plate.

In FIG. 6, the light emitted from the OLED D is transmitted through the first electrode 510 and the color filter layer 480 is disposed under the OLED D. The organic light emitting display device 400 can be a bottom-emission type. Alternatively, the light emitted from the OLED D is transmitted through the second electrode 520 and the color filter layer 480 can be disposed on the OLED D when the organic light emitting display device 400 is a top-emission type. In this case, the color filter layer 480 can be attached to the OLED D by adhesive layer. Alternatively, the color filter layer 480 can be disposed directly on the OLED D. When the organic light emitting display device 400 is a top-emission type, a reflective electrode or a reflective layer can be further disposed under the first electrode 510. For example, the reflective electrode or the reflective layer can include silver or APC alloy.

In addition, a color conversion layer can be formed or disposed between the OLED D and the color filter layer 480. The color conversion layer can include a red color conversion layer, a green color conversion layer and a blue color conversion layer each of which is disposed correspondingly to each pixel region (RP, GP and BP), respectively, so as to convert the white (W) color light to each of a red, green and blue color lights, respectively. For example, the color conversion layer can include quantum dots so that the color purity of the organic light emitting display device 400 can be further improved. Alternatively, the organic light emitting display device 400 can comprise the color conversion layer instead of the color filter layer 480.

As described above, the white (W) color light emitted from the OLED D is transmitted through the red color filter pattern 482, the green color filter pattern 484 and the blue color filter pattern 486 each of which is disposed correspondingly to the red pixel region RP, the green pixel region GP and the blue pixel region BP, respectively, so that red, green and blue color lights are displayed in the red pixel region RP, the green pixel region GP and the blue pixel region BP.

An OLED that can be applied into the organic light emitting display device will now be described in more detail. An example of the OLED D of FIG. 6 is shown in FIG. 7 as an OLED D2. Particularly, FIG. 7 illustrates a schematic cross-sectional view of an organic light emitting diode having a tandem structure of three emitting parts.

As illustrated in FIG. 7, the OLED D2 in accordance with another embodiment includes first and second electrodes 510 and 520 facing each other and an emissive layer 530 disposed between the first and second electrodes 510 and 520. The emissive layer 530 includes a first emitting part 600 disposed between the first and second electrodes

510 and 520, a second emitting part 700 disposed between the first emitting part 600 and the second electrode 520, a third emitting part 800 disposed between the second emitting part 700 and the second electrode 520, a fourth emitting part 900 disposed between the third emitting part 800 and the second electrode 520, a first charge generation layer (CGL1) 690 disposed between the first and second emitting parts 600 and 700, and a second charge generation layer (CGL2) 790 disposed between the second and third emitting parts 700 and 800, and a third charge generation layer (CGL3) 890 disposed between the third and fourth emitting parts 800 and 900.

The first electrode 510 can be an anode and can include a conductive material having relatively high work function value such as TCO. The second electrode 520 can be a cathode and can include a conductive material with a relatively low work function value.

The first emitting part 600 includes a first emitting material layer (EML1) 640. The first emitting part 600 can include at least one of a hole injection layer (HIL) 610 disposed between the first electrode 510 and the EML1 640, a first hole transport layer (HTL1) 620 disposed between the HIL 610 and the EMI,1 640, and a first electron transport layer (ETL1) 680 disposed between the EML1 640 and the CGL1 690. Alternatively or additionally, the first emitting part 600 can further include a first electron blocking layer (EBL1) 630 disposed between the HTL1 620 and the EML1 640 and/or a first hole blocking layer (HBL1) 670 disposed between the EML1 640 and the ETL1 680.

The second emitting part 700 includes a second emitting material layer (EML2) 740. The second emitting part 700 can include at least one of a second hole transport layer (HTL2) 720 disposed between the CGL1 690 and the EMI,2 740 and a second electron transport layer (ETL2) 780 disposed between the EMI,2 740 and the CGL2 790. Alternatively or additionally, the second emitting part 700 can further include at least one of a second electron blocking layer (EBL2) 730 disposed between the HTL2 720 and the EMI,2 740 and a second hole blocking layer (HBL2) 770 disposed between the EMI,2 740 and the ETL2 780.

The third emitting part 800 includes a third emitting material layer (EML3) 840. The third emitting part 800 can include at least one of a third hole transport layer (HTL3) 820 disposed between the CGL2 790 and the EML3 840 and a third electron transport layer (ETL3) 880 disposed between the EML3 840 and the CGL3 890. Alternatively or additionally, the third emitting part 800 can further include at least one of a third electron blocking layer (EBL3) 830 disposed between the HTL3 820 and the EML3 840 and a third hole blocking layer (HBL3) 870 disposed between the EML3 840 and the ETL3 880.

The fourth emitting part 900 includes a fourth emitting material layer (EML4) 940. The fourth emitting part 900 can include at least one of a fourth hole transport layer (HTL4) 920 disposed between the CGL3 890 and the EMI,4 940, a fourth electron transport layer (ETL4) 980 disposed between the EMI,4 940 and the second electrode 520, and an electron injection layer (EIL) 990 disposed between the ETL4 980 and the second electrode 520. Alternatively or additionally, the fourth emitting part 900 can further include at least one of a fourth electron blocking layer (EBL4) 930 disposed between the HTL4 920 and the EMI,4 940 and a fourth hole blocking layer (HBL4) 970 disposed between the EMI,4 940 and the ETL4 980.

The HIL 610 is disposed between the first electrode 510 and the HTL1 620 and improves an interface property between the inorganic first electrode 510 and the organic HTL1 620. In one embodiment, hole injecting material in the HIL 610 can include, but is not limited to, MTDATA, NATA, 1T-NATA, 2T-NATA, CuPc, TCTA, NPB (NPD), DNTPD, HAT-CN, F4-TCNQ, F6-TCNNQ, TDAPB, PEDOT/PSS, N-(biphenyl-4-yl)-9,9-dimethyl-N-(4-(9-phenyl-9H-carbazol-3-yl)phenyl)-9H-fluoren-2-amine, NPNPB, TAPC, the compound of Chemical Formula 5 and/or combinations thereof. Alternatively, the HIL 610 can include the hole transporting material doped with the hole injecting material. In certain embodiments, the HIL 610 can be omitted in compliance of the OLED D2 property.

Each of the HTL1 620, the HTL2 720, the HTL3 820 and the HTL4 920 can facilitate the hole transportation in the first emitting part 600, the second emitting part 700, the third emitting part 800 and the fourth emitting part 900, respectively. In one embodiment, hole transporting material in each of the HTL1 620, the HTL2 720, the HTL3 820 and the HTL4 920 can independently include, but is not limited to, TPD, NPB (NPD), CBP, Poly-TPD, TFB, TAPC, DCDPA, N-(biphenyl-4-yl)-9,9-dimethyl-N-(4-(9-phenyl-9H-carbazol-3-yl)phenyl)-9H-fluoren-2-amine, N-(biphenyl-4-yl)-N-(4-(9-phenyl-9H-carbazol-3-yl)phenyl)biphenyl-4-amine, N-([1,1'-Biphenyl]-4-yl)-9,9-dimethyl-N-(4-(9-phenyl-9H-carbazol-3-yl)phenyl)-9H-fluoren-2-amine and/or combination thereof.

Each of the ETL1 680, the ETL2 780, the ETL3 880 and the ETL4 980 can facilitate electron transportation in the first emitting part 600, the second emitting part 700, the third emitting part 800 and the fourth emitting part 900, respectively. As an example, electron transporting material in each of the ETL1 680, the ETL2 780, the ETL3 880 and the ETL4 980 can independently include at least one of an oxadiazole-containing compound, a triazole-containing compound, a phenanthroline-containing compound, a benzoxazole-containing compound, a benzothiazole-containing compound, a benzimidazole-containing compound and a triazine-containing compound. For example, the electron transporting material in each of the ETL1 680, the ETL2 780, the ETL3 880 and the ETL4 980 can independently include, but is not limited to, $Alq_3$, PBD, spiro-PBD, Liq, TPBi, BAlq, Bphen, NBphen, BCP, TAZ, NTAZ, TpPyPB, TmPPPyTz, PFNBr, TPQ, TSPO1, ZADN and/or combinations thereof.

The EII, 990 is disposed between the second electrode 520 and the ETL4 980, and can improve physical

properties of the second electrode 520 and therefore, can enhance the lifespan of the OLED D2. In one embodiment, electron injecting material in the EIl, 990 can include, but is not limited to, an alkali metal halide or an alkaline earth metal halide such as LiF, CsF, NaF, $BaF_2$ and the like, and/or an organometallic Compound such as Liq, lithium benzoate, sodium stearate, and the like.

In one embodiment, electron blocking material in each of the EBL1 630, the EBL2 730, the EBL3 830 and the EBL4 930 can independently include, but is not limited to, TCTA, Tris[4-(diethylamino)phenyl]amine, N-(biphenyl-4-yl)-9,9-dimethyl-N-(4-(9-phenyl-9H-carbazol-3-yl)phenyl)-9H-fluorene-2-amine, TAPC, MTDATA, mCP, mCBP, CuPc, DNTPD, TDAPB, DCDPA, 2,8-bis(9-phenyl-9H-carbazol-3-yl)dibenzo[b,d]thiophene and/or combinations thereof, respectively.

In one embodiment, hole blocking material in each of the HBL1 670, the HBL2 770, the HBL3 870 and the HBL4 970 can independently include, but is not limited to, at least one of an oxadiazole-containing compound, a triazole-containing compound, a phenanthroline-containing compound, a benzoxazole-containing compound, a benzothiazole-containing compound, a benzimidazole-containing compound, and a triazine-containing compound. For example, the hole blocking material in each of the HBL1 670, the HBL2 770, the HBL3 870 and the HBL4 970 can independently include, but is not limited to, BCP, BAlq, $Alq_3$, PBD, spiro-PBD, Liq, B3PYMPM, DPEPO, 9-(6-(9H-carbazol-9-yl)pyridine-3-yl)-9H-3,9'-bicarbazole, TSPO1 and/or combinations thereof, respectively.

The CGL1 690 is disposed between the first emitting part 600 and the second emitting part 700. The CGL1 690 includes a first N-type charge generation layer (N-CGL1) 692 disposed between the ETL1 680 and the HTL2 720, and a first P-type charge generation layer (P-CGL1) 694 disposed between the N-CGL1 692 and the HTL2 720.

The CGL2 790 is disposed between the second emitting part 700 and the third emitting part 800. The CGL2 790 includes a second N-type charge generation layer (N-CGL2) 792 disposed between the ETL2 780 and the HTL3 820, and a second P-type charge generation layer (P-CGL2) 794 disposed between the N-CGL2 792 and the HTL3 820.

The CGL3 890 is disposed between the third emitting part 800 and the fourth emitting part 900. The CGL3 890 includes a third N-type charge generation layer (N-CGL3) 892 disposed between the ETL3 880 and the HTL4 920, and a third P-type charge generation layer (P-CGL3) 894 disposed between the N-CGL3 892 and the HTL4 920.

Each of the N-CGL1 692, the N-CGL2 792 and the N-CGL3 892 provides electrons to the EMI,1 640 of the first emitting part 600, the EMI,2 740 of the second emitting part 700 and the EML3 840 of the third emitting part 800, respectively. Each of the P-CGL1 694, the P-CGL2 794 and the P-CGL3 894 provides holes to the EMI,2 740 of the second emitting part 700, the EML3 840 of the third emitting part 800 and the EML4 940 of the fourth emitting part 900, respectively.

Each of the N-CGL1 692, the N-CGL2 792 and the N-CGL3 892 can be an organic layer with electron transporting material doped with an alkali metal such as Li, Na, K and Cs and/or an alkaline earth metal such as Mg, Sr, Ba and Ra. For example, the contents of the alkali metal and/or the alkaline earth metal in each of the N-CGL1 692, the N-CGL2 792 and the N-CGL3 892 can be, but is not limited to, between about 0.1 wt.% and about 30 wt.%, for example, about 1 wt.% and about 10 wt.%.

In one embodiment, each of the P-CGL1 694, the P-CGL2 794 and the P-CGL3 894 can include, but is not limited to, inorganic material selected from the group consisting of $WO_x$, $MoO_x$, $Be_2O_3$, $V_2O_5$ and/or combinations thereof. In another embodiment, each of the P-CGL1 694, the P-CGL2 794 and the P-CGL3 894 can include organic material of the hole transporting material doped with the hole injecting material (e.g., organic material such as HAT-CN, F4-TCNQ and/or F6-TCNNQ). In this case, the contents of the hole injecting material in the P-CGL1 694, the P-CGL2 794 and the P-CGL3 894 can be, but is not limited to, between about 2 wt.% and about 15 wt.%.

In one embodiment, two of the EMI,1 640, the EMI,2 740, the EML3 840 and the EML4 940 can emit blue color light, one of the EMI,1 640, the EMI,2 740, the EML3 840 and the EML4 940 can emit green color light and another of the EMI,1 640, the EMI,2 740, the EML3 840 and the EML4 940 can emit red and blue color lights, so that the OLED D2 can realize white (W) emission. Hereinafter, the OLED D2 where the EMI,2 740 and the EMI,4 940 emit blue color light, the EML3 840 emits green color light and the EMI,1 640 emits red and blue color lights will be described in more detail.

The EML1 640 includes a first blue emitting material layer (B-EMI,1) 650 and a red emitting material layer (R-EML) 660 disposed between the B-EML1 650 and the CGL1 690.

The B-EML1 650 includes first host (blue host) 652 and a blue emitter (blue dopant) 654. The first host 652 can include at least one of a P-type blue host and an N-type blue host. The blue emitter 654 can include at least one of blue phosphorescent material, blue fluorescent material and blue delayed fluorescent material. The R-EMI, 660 includes second host (red host) 662 and a red emitter (red dopant) 664. The second host 662 can include at least one of a P-type red host and an N-type red host. The red emitter 664 can include at least one of red phosphorescent material, red fluorescent material and red delayed fluorescent material.

The kinds, contents and the energy levels of the first host 652, the blue emitter 654, the second host 662 and the red emitter 664 can be identical to the corresponding materials with referring to FIGs. 3 and 5.

Each of the EML2 740 and the EML4 940 can be a second blue emitting material layer (B-EML2) and a third blue emitting material layer (B-EML3), respectively. In this case, each of the EML2 740 and the EML4 940 can be a blue

emitting material layer, a sky blue emitting material layer and/or a deep blue emitting material layer. Each of the EML2 740 and the EML4 940 can independently include a blue host and a blue emitter, respectively.

The blue host in each of the EMI,2 740 and the EML4 940 can include at least one of a P-type blue host and an N-type blue host. The blue emitter in each of the EML2 740 and the EML4 940 can include at least one of blue phosphorescent material, blue fluorescent material and blue delayed fluorescent material.

In one embodiment, the blue host in each of the EML2 740 and the EML4 940 can be identical to the first host 652. In another embodiment, the blue host in each of the EML2 740 and the EML4 940 can include, but is not limited to, mCP, 9-(3-(9H-carbazol-9-yl)phenyl)-9H-carbazole-3-carbonitrile (mCP-CN), mCBP, CBP-CN, 9-(3-(9H-Carbazol-9-yl)phenyl)-3-(diphenylphosphoryl)-9H-carbazole (mCPPO1) 3,5-Di(9H-carbazol-9-yl)biphenyl (Ph-mCP), TSPO1, 9-(3'-(9H-carbazol-9-yl)-[1,1'-biphenyl]-3-yl)-9H-pyrido[2,3-b]indole (CzBPCb), Bis(2-methylphenyl)diphenylsilane (UGH-1), 1,4-Bis(triphenylsilyl)benzene (UGH-2), 1,3-Bis(triphenylsilyl)benzene (UGH-3), 9,9-Spirobifluoren-2-yl-diphenyl-phosphine oxide (SPPO1), 9,9'-(5-(Triphenylsilyl)-1,3-phenylene)bis(9H-carbazole) (SimCP), AND, MADN and/or combinations thereof.

For example, the blue emitter in the EML2 740 and the EML4 940 can be identical to or different from the blue emitter 654. In another embodiment, the blue emitter in the EML2 740 can be identical to or different from the blue emitter in the EML4 940. The blue emitter in the EML2 740 and the EML4 940 can include blue phosphorescent material, blue fluorescent material and blue delayed fluorescent material.

In one embodiment, the contents of the blue host in each of the EML2 740 and the EML4 940 can be between about 50 wt.% and about 99 wt.%, for example, about 80 wt.% and about 95 wt.%. Further, the contents of the blue emitter in each of the EML2 740 and the EML4 940 can be between about 1 wt.% and about 50 wt.%, for example, about 5 wt.% and about 20 wt.%, but is not limited thereto. When each of the EML2 740 and the EML4 940 includes both the P-type blue host and the N-type blue host, the P-type blue host and the N-type blue host can be mixed with, but is not limited to, a weight ratio of about 4:1 to about 1:4, for example, about 3:1 to about 1:3.

The EML3 840 can include a green host and a green emitter (green dopant). The green host in the EML3 840 can include at least one of a P-type green host and an N-type green host. The green emitter in the EML3 840 can include at least one of green phosphorescent material, green fluorescent material and green delayed fluorescent material.

For example, the green host in the EML3 840 can include, but is not limited to, 9-(3-(9H-carbazol-9-yl)phenyl)-9H-carbazole-3-carbonitrile (mCP-CN), CBP, mCBP, mCP, DPEPO, 2,8-bis(diphenylphosphoryl)dibenzothiophene (PPT), TmPyPB, 2,6-Di(9H-carbazol-9-yl)pyridine (PYD-2Cz), 2,8-di(9H-carbazol-9-yl)dibenzothiophene (DCzDBT), 3',5'-Di(carbazol-9-yl)-[1,1'-bipheyl]-3,5-dicarbonitrile (DCzTPA), 4'-(9H-carbazol-9-yl)biphenyl-3,5-dicarbonitrile(4'-(9H-carbazol-9-yl)biphenyl-3,5-dicarbonitrile (pCzB-2CN), 3'-(9H-carbazol-9-yl)biphenyl-3,5-dicarbonitrile (mCzB-2CN), TSPO1, 9-(9-phenyl-9H-carbazol-6-yl)-9H-carbazole (CCP), 4-(3-(triphenylen-2-yl)phenyl)dibenzo[b,d]thiophene, 9-(4-(9H-carbazol-9-yl)phenyl)-9H-3,9'-bicarbazole, 9-(3-(9H-carbazol-9-yl)phenyl)-9H-3,9'-bicarbazole, 9-(6-(9H-carbazol-9-yl)pyridin-3-yl)-9H-3,9'-bicabazole, 9,9'-Diphenyl-9H,9'H-3,3'-bicarbazole (BCzPh), 1,3,5-Tris(carbazole-9-yl)benzene (TCP), TCTA, 4,4'-Bis(carbazole-9-yl)-2,2'-dimethylbipheyl (CDBP), 2,7-Bis(carbazole-9-yl)-9,9-dimethylfluorene (DMFL-CBP), 2,2',7,7'-Tetrakis(carbazole-9-yl)-9,9-spirofluorene (Spiro-CBP), 3,6-Bis(carbazole-9-yl)-9-(2-ethylhexyl)-9H-carbazole (TCz1) and/or combinations thereof.

In another embodiment, the green emitter in the EML3 840 can include, but is not limited to, [Bis(2-phenylpyridine)](pyridyl-2-benzofuro[2,3-b]pyridine)iridium, Tris[2-phenylpyridine]iridium(III) ($Ir(ppy)_3$), fac-Tris(2-phenylpyridine)iridium(III) (fac-$Ir(ppy)_3$), Bis(2-phenylpyridine)(acetylacetonate)iridium(III) ($Ir(ppy)_2(acac)$), Tris[2-(p-tolyl)pyridine]iridium(III) ($Ir(mppy)_3$), Bis(2-(naphthalene-2-yl)pyridine)(acetylacetonate)iridium(III) ($Ir(npy)_2acac$), Tris(2-phenyl-3-methyl-pyridine)iidium ($Ir(3mppy)_3$), fac-Tris(2-(3-p-xylyl)phenyl)pyridine iridium(III) (TEG) and/or combinations thereof.

In one embodiment, the contents of the green host in the EML3 840 can be between about 50 wt.% and about 99 wt.%, for example, about 80 wt.% and about 95 wt.%. Further, the contents of the green emitter in the EML3 840 can be between about 1 wt.% and about 50 wt.%, for example, about 5 wt.% and about 20 wt.%, but is not limited thereto. When the EML3 840 includes both the P-type green host and the N-type green host, the P-type green host and the N-type green host can be admixed with, but is not limited to, a weight ratio of about 4:1 to about 1:4, for example, about 3:1 to about 1:3.

At least one of the multiple emitting parts 600, 700, 800 and 900 includes the R-EMI, 660 disposed contacted to the B-EML1 650. Exciton recombination zone is generated uniformly within the EML1 640 so that blue luminous efficiency can be maintained stably by controlling the energy levels of the first host 652 and/or the second host 662. As the exciton quenching is prevented, the driving voltage of the OLED D2 cannot be raised with stable red luminous lifespan. In addition, the luminous properties of the OLED D2 can be further improved by applying a tandem structure.

## EXAMPLES

The following examples are not intended to be limiting. The above invention provides many different embodiments for implementing the features of the invention, and the following examples describe certain embodiments. It will

be appreciated that other modifications and methods known to one of ordinary skill in the art can also be applied to the following experimental procedures, without departing from the scope of the invention.

Example 1 (Ex.1): Fabrication of OLED

An organic light emitting diode where a blue emitting material layer and a red emitting material layer were contacted to each other was fabricated. A glass substrate onto which ITO (1100 Å) was coated as a thin film was washed and ultrasonically cleaned by solvent such as isopropyl alcohol, acetone and dried at 100°C oven. The substrate was transferred to a vacuum chamber for depositing emissive layer as the following order:

Hole injection layer ($MgF_2$, 70 Å); hole transport layer (HTL, DNTPD, 150 Å); blue emitting material layer (B-EML, Compound BH7 in Chemical Formula 2 (first host, MADN, HOMO: -6.0 eV, LUMO: -3.0 eV, 95-99 wt.%), blue emitter (DABNA-1, 1-5 wt.%), 100-300 Å); red emitting material layer (R-EML, Compound RH1 in Chemical Formula 4 (second host, HOMO: -5.57 eV, LUMO: -2.47 eV, 95-98 wt.%), red emitter ($Ir(piq)_3$, 2-5 wt.%), 100-300 Å); electron transport layer (ETL, TPBi, 220 Å); electron injection layer (Bphen (99 wt.%), Li (1 wt.%), 170 Å); and cathode (Al, 1500 Å).

The difference between the HOMO energy level of the first host and the HOMO energy level of the second host is 0.43 eV.

The fabricated OLED was encapsulated with glass and then transferred from the deposition chamber to a dry box in order to form a film. Then the OLED was encapsulated with UV-cured epoxy resin and water getter. The structures of materials of hole transporting material, blue host (first host), blue emitter, red emitter, electron transporting material and electron injecting material are illustrated in the following:

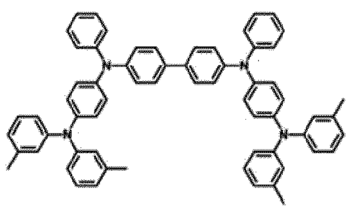
DNTPD

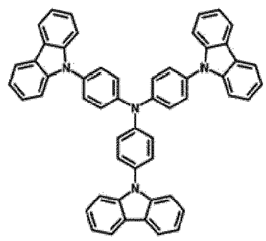
TCTA

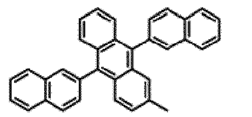
MADN

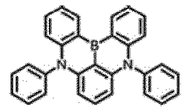
DABNA-1

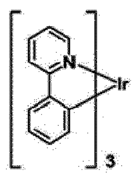
Ir(ppy)3

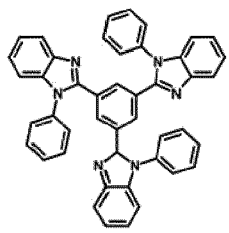
TPBi

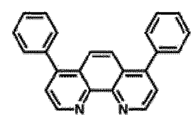
Bphen

Comparative Example 1 (Ref. 1): Fabrication of OLED

An OLED was fabricated using the same procedure and the same material as Example 1, except that a red emitting material layer (100-300 Å) including a host (quinoxaline-based Reference Compound 1 (Ref. 1), HOMO: -5.21 eV, LUMO: -2.91 eV, 95-98 wt.%) and the red emitter $Ir(piq)_3$ (2-5 wt.%), and a blue emitting material layer (100-300 Å) including a host (Compound BH7, 95-99 wt.%) and the blue emitter DABNA-1 (1-5 wt.%) were sequentially laminated on the HTL instead of the B-EML and the R-EML.

[Comparative Red Host]

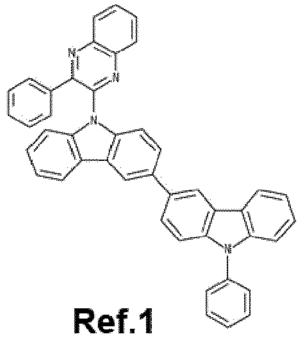

**Ref.1**

Experimental Example 1: Measurement of Electro-Optical Properties of OLEDs

The luminous properties for each of the OLEDs, fabricated in Example 1 and Comparative Example 1, were measured. Each of the OLEDs were connected to an external power source and then luminous properties for all the OLEDs were evaluated using a constant current source (KEITHLEY) and a photometer PR650 at room temperature. In particular, electroluminescence (EL) spectrum, and driving voltage (V), current efficiency (cd/A, %), power efficiency (lm/W), external quantum efficiency (EQE, %), luminance (cd/$m^2$), color coordinates (CIEx, CIEy) and F/W panel efficiency (cd/A) for each of the OLEDs were measured. Measurement results are indicated in the following Table 1 and FIGS. 8 and 9.

Table 1: Electro-Optical Properties of OLED

| Sample | Electro-Optical property | | | | | | | | F/W cd/A | |
|---|---|---|---|---|---|---|---|---|---|---|
| | V | V* | cd/A | lm/W | EQE | cd/$m^2$ | CIEx | CIEy | R | B |
| Ref. 1 | 3.18 | 4.07 | 18.97 | 18.74 | 19.25 | 1897.0 | 0.69 | 0.31 | 11.7 | 0.08 |
| Ex. 1 | 5.20 | 6.92 | 9.30 | 5.62 | 9.64 | 930.2 | 0.42 | 0.20 | 5.6 | 0.68 |
| *: 100 mA/$cm^2$ | | | | | | | | | | |

As indicated in Table 1 and FIGS. 8-9, in the OLED fabricated in Comparative Example 1, the blue luminous efficiency was very low, the different between the blue luminous efficiency and the red luminous efficiency was very large and the luminous lifespan was very lowered, and therefore, there was disadvantages as a red-blue junction device.

On the contrary, compared to the OLED fabricated in Comparative Example 1, in the OLED fabricated in Example 1, the blue luminous efficiency was increased by eight times to implement stable blue emission and the luminous lifespan was greatly improved.

Example 2 (Ex. 2): Fabrication of OLED

An OLED was fabricated using the same procedure and the same material as Example 1, except that Compound RH2 in Chemical Formula 4 (HOMO: -5.57 eV, LUMO: -2.47 eV) instead of the Compound RH1 in the R-EMI, was used as the second host. The difference between the HOMO energy level of the first host and the HOMO energy level of the second host is 0.43 eV.

Comparative Example 2 (Ref. 2): Fabrication of OLED

An OLED was fabricated using the same procedure and the same material as Example 2, except that the following pyrene-based Reference Compound 2 (Ref. 2) (HOMO: -5.75 eV, LUMO: -2.67 eV) instead of the Compound BH7 as the first host in the B-EML and the quinoxaline-based Reference Compound 1 (Ref. 1) instead of the Compound RH2 as the second host in the R-EMI, were used. The difference between the HOMO energy level of the first host and the HOMO energy level of the second host is 0.54 eV.

Comparative Example 3 (Ref. 3): Fabrication of OLED

An OLED was fabricated using the same procedure and the same material as Example 2, except the quinoxaline-based Reference Compound 1 instead of the Compound RH2 was used as the second host in the R-EML. The difference between the HOMO energy level of the first host and the HOMO energy level of the second host is 0.79 eV.

[Comparative Blue Host]

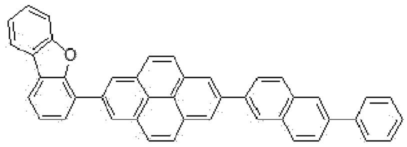

**Ref.2**

Experimental Example 2: Measurement of Electro-Optical Properties of OLEDs

The luminous properties for each of the OLEDs, fabricated in Example 2 and Comparative Examples 2-3, were measured as Experimental Example 1. The red luminous lifespan (R $LT_{95}$) and the blue luminous lifespan (B $LT_{95}$) were measured as time period when the luminance was reduced to 95% level from the initial luminance at a current density of 40 mA/$cm^2$ and 40°C. The measurement results are indicated in the following Table 2 and FIGS. 10 to 12.

Table 2: Electro-Optical Properties of OLED

| Sample | Electro-Optical property | | | | | F/W cd/A | |
|---|---|---|---|---|---|---|---|
| | V | V* | EQE | R $LT_{95}$ | B$LT_{95}$ | R | B |
| Ref. 2 | 3.48 | 4.35 | 4.1 | | 95 | 3.14 | 0.09 |
| Ref. 3 | 3.90 | 4.68 | 4.5 | | 290 | 0.99 | 0.76 |
| Ex. 2 | 4.35 | 5.35 | 7.5 | 800 | 380 | 4.12 | 0.60 |
| *: 100 mA/$cm^2$ | | | | | | | |

As indicated in Table 2 and FIGS. 10-12, compared to the OLEDs fabricated in Comparative Examples 1-2 where the difference between the first host and the second host are designed to be more than 0.5 eV, in the OLED fabricated in Example 2, stable red emission and blue emission can be realized and the blue luminous lifespan was greatly improved. In addition, compared to the OLEDs fabricated in Comparative Examples 2 and 3, in the OLED fabricated in Example 2, the EQE was improved by almost two times. On the contrary, in the OLED fabricated in Comparative Example 2, the blue emission was little occurred, and therefore, there was a disadvantage as the blue-red junction device. In addition, in the OLED fabricated in Comparative Example 2, the blue luminous efficiency was greatly lowered and the blue luminous lifespan was greatly reduced compared to the OLED fabricated in Example 2.

It will be apparent to those skilled in the art that various modifications and variations can be made in the present invention without departing from the scope of the invention. Thus, it is intended that the present invention cover the modifications and variations of the present invention provided they come within the scope of the appended claims.

## Claims

**1.** An organic light emitting diode, comprising:

a first electrode;
a second electrode facing the first electrode; and
an emissive layer disposed between the first electrode and the second electrode, and comprising at least one emitting material layer,
wherein each of the at least one emitting material layer comprises:

a blue emitting material layer comprising a first host; and
a red emitting material layer disposed between the blue emitting material layer and the second electrode, and comprising a second host,

wherein a highest occupied molecular orbital energy (HOMO) energy level of the first host and a HOMO energy level of the second host satisfy the following relationship in Equation (1):

$$-0.5\ \text{eV} \le \text{HOMO}^{H1} - \text{HOMO}^{H2} < 0\ \text{eV} \qquad (1)$$

wherein, in Equation (1), $\text{HOMO}^{H1}$ indicates a HOMO energy level of the first host and $\text{HOMO}^{H2}$ indicates a HOMO energy level of the second host.

2. The organic light emitting diode of claim 1, wherein the HOMO energy level of the first host and the HOMO energy level of the second host satisfy the following relationship in Equation (2):

$$-0.5\ \text{eV} \le \text{HOMO}^{H1} - \text{HOMO}^{H2} \le -0.3\ \text{eV} \qquad (2)$$

wherein, in Equation (2), $\text{HOMO}^{H1}$ indicates a HOMO energy level of the first host and $\text{HOMO}^{H2}$ indicates a HOMO energy level of the second host.

3. The organic light emitting diode of claim 1 or 2, wherein the first host comprises an organic compound having the following structure of Chemical Formula 1:

[Chemical Formula 1]

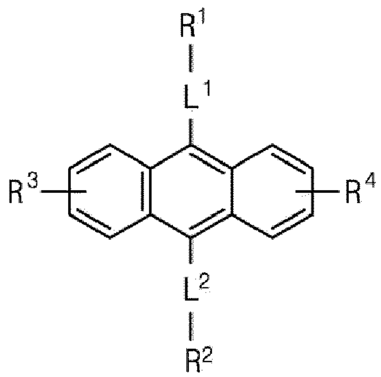

wherein, in Chemical Formula 1,
each of $R^1$ and $R^2$ is independently an unsubstituted or substituted $C_6$-$C_{30}$ aryl group or an unsubstituted or substituted $C_3$-$C_{30}$ hetero aryl group;
each of $R^3$ and $R^4$ is independently hydrogen, an unsubstituted or substituted $C_1$-$C_{20}$ alkyl group, an unsubstituted or substituted $C_6$-$C_{30}$ aryl group or an unsubstituted or substituted $C_3$-$C_{30}$ hetero aryl group; and
each of $L^1$ and $L^2$ is independently a single bond, an unsubstituted or substituted $C_6$-$C_{30}$ arylene group or an unsubstituted or substituted $C_3$-$C_{30}$ hetero arylene group.

4. The organic light emitting diode of any one of claims 1 to 3, wherein the second host comprises an organic compound having the following structure of Chemical Formula 3:

[Chemical Formula 3]

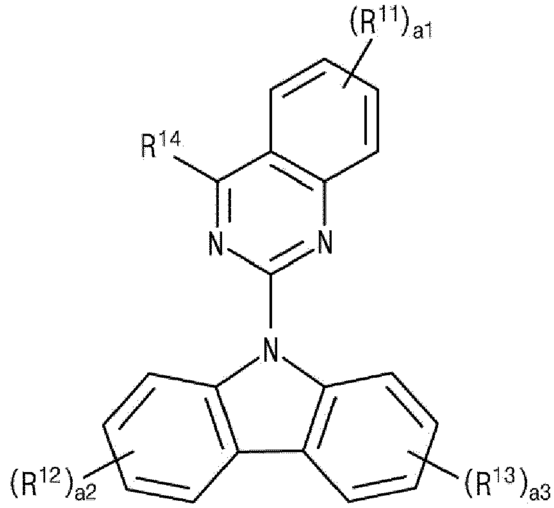

wherein, in Chemical Formula 3,
$R^{11}$ is an unsubstituted or substituted $C_6$-$C_{30}$ aryl group or an unsubstituted or substituted $C_3$-$C_{30}$ hetero aryl group, where each $R^{11}$ is identical to or different from each other when a1 is 2, 3 or 4;
each of $R^{12}$ and $R^{13}$ is independently an unsubstituted or substituted $C_6$-$C_{30}$ aryl group or an unsubstituted or substituted $C_3$-$C_{30}$ hetero aryl group, where each $R^{12}$ is identical to or different from each other when a2 is 2, 3 or 4, each $R^{13}$ is identical to or different from each other when a3 is 2, 3 or 4, and where at least one of $R^{12}$ and $R^{13}$ includes an unsubstituted or substituted $C_{10}$-$C_{30}$ fused hetero aryl group, or
optionally,
two adjacent $R^{12}$ when a2 is 2, 3 or 4, and/or
two adjacent $R^{13}$ when a3 is 2, 3 or 4
can be further linked together to form an unsubstituted or substituted $C_6$-$C_{10}$ aromatic ring;
$R^{14}$ is hydrogen, an unsubstituted or substituted $C_1$-$C_{20}$ alkyl group, an unsubstituted or substituted $C_6$-$C_{30}$ aryl group or an unsubstituted or substituted $C_3$-$C_{30}$ hetero aryl group; and
each of a1, a2 and a3 is independently 0, 1, 2, 3 or 4, where at least one of a1, a2 and a3 is not 0.

**5.** The organic light emitting diode of any one of claims 1 to 4, wherein the second host is at least one of the following organic compounds:

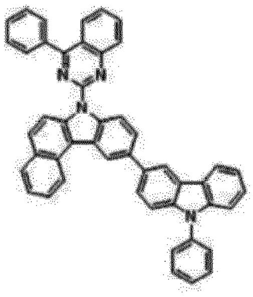

RH1

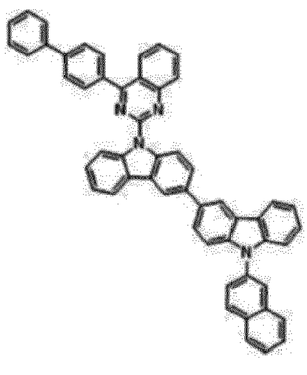

RH2

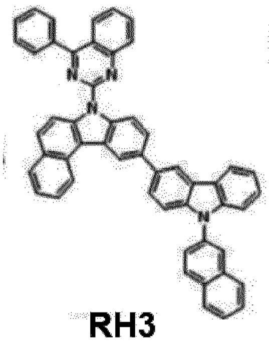

RH3

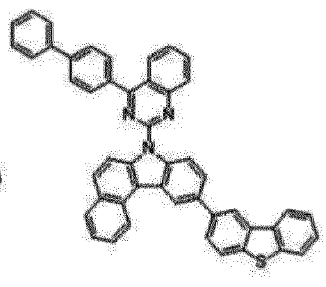

RH4

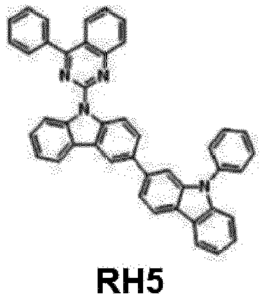

RH5

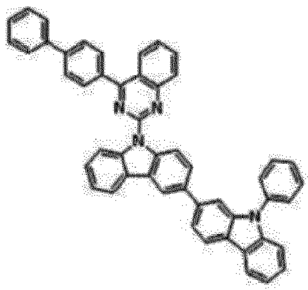

RH6

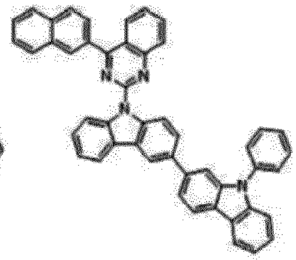

RH7

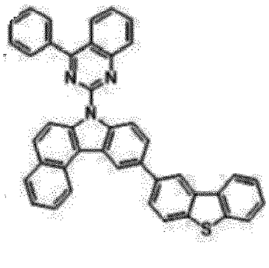

RH8

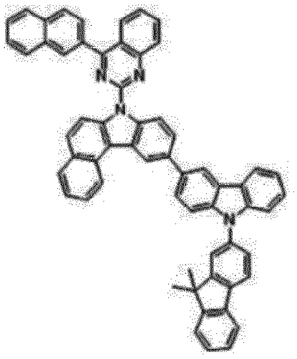

RH9

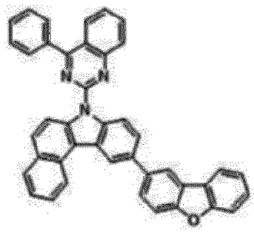

RH10

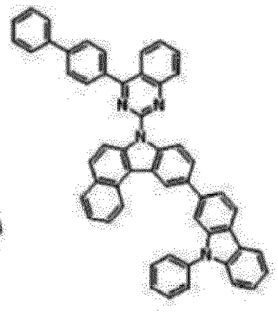

RH11

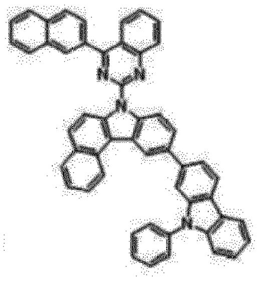

RH12

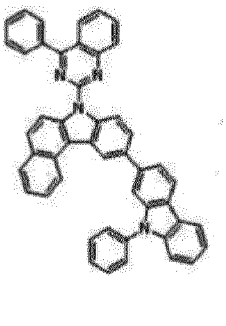

RH13

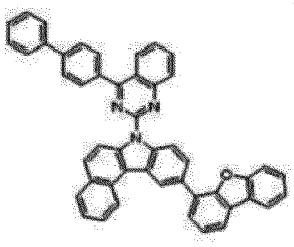

RH14

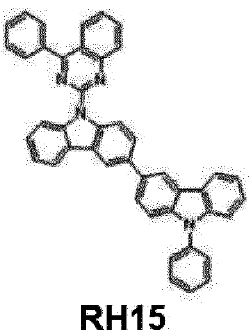

RH15

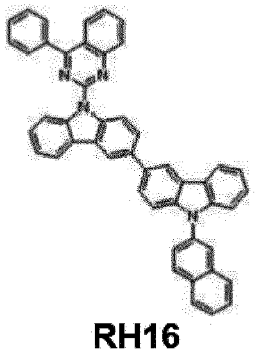

RH16

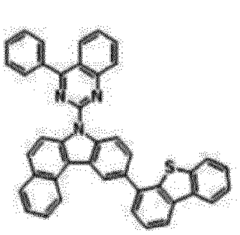

RH17

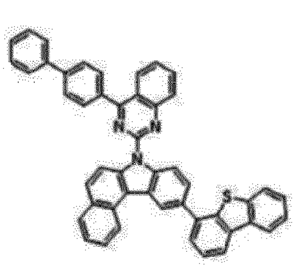

RH18

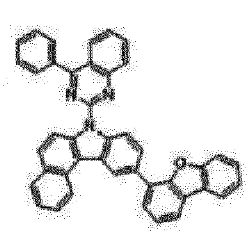

RH19

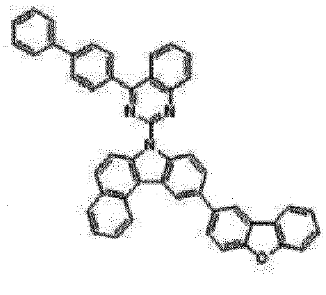

RH20

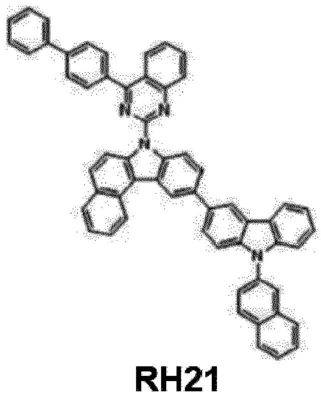

RH21

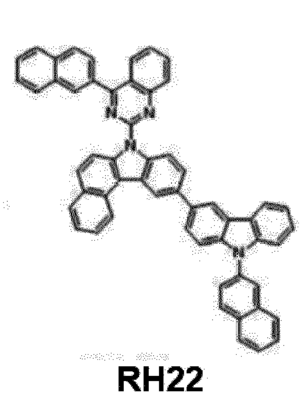

RH22

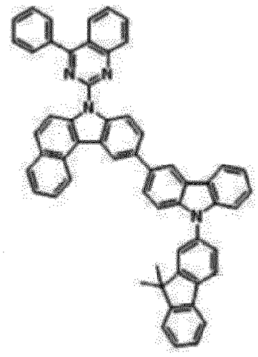

RH23

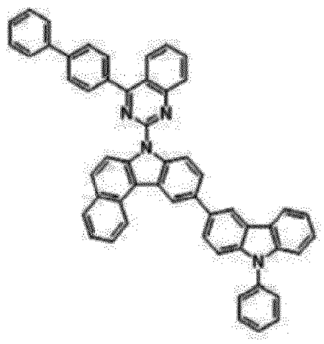

RH24

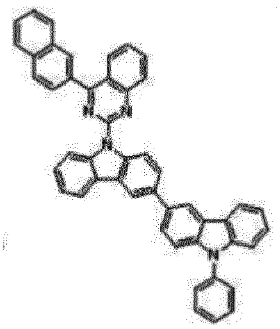

RH25

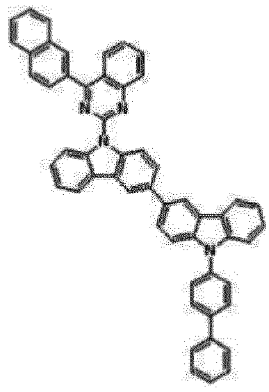

RH26

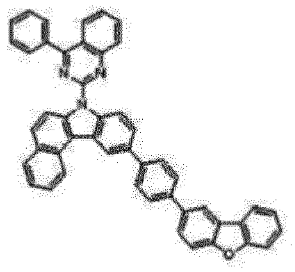

RH27

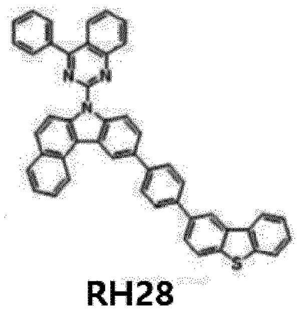

RH28 .

**6.** The organic light emitting diode of any one of claims 1 to 5, wherein the emissive layer comprises:

a first emitting part disposed between the first electrode and the second electrode;
a second emitting part disposed between the first emitting part and the second electrode;
a third emitting part disposed between the second emitting part and the second electrode;
a fourth emitting part disposed between the third emitting part and the second electrode;
a first charge generation layer disposed between the first emitting part and the second emitting part;
a second charge generation layer disposed between the second emitting part and the third emitting part; and
a third charge generation layer disposed between the third emitting part and the fourth emitting part, and
wherein one of the first emitting part, the second emitting part, the third emitting part and the fourth emitting part comprises the blue emitting material layer and the red emitting material layer.

**7.** An organic light emitting diode, comprising:

a first electrode;
a second electrode facing the first electrode; and
an emissive layer disposed between the first electrode and the second electrode, and comprising at least one

emitting material layer,
wherein the at least one emitting material layer comprises:

a blue emitting material layer comprising a first host; and
a red emitting material layer disposed between the blue emitting material layer and the second electrode, and comprising a second host,
wherein the first host comprises an organic compound having the following structure of Chemical Formula 1, and
wherein the second host comprises an organic compound having the following structure of Chemical Formula 3:

[Chemical Formula 1]

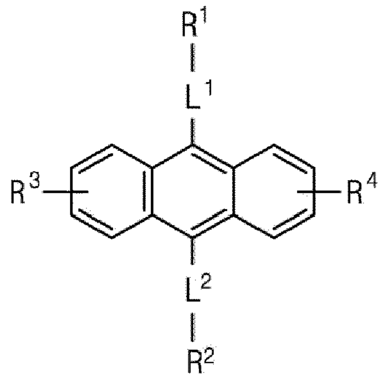

wherein, in Chemical Formula 1,
each of $R^1$ and $R^2$ is independently an unsubstituted or substituted $C_6$-$C_{30}$ aryl group or an unsubstituted or substituted $C_3$-$C_{30}$ hetero aryl group;
each of $R^3$ and $R^4$ is independently hydrogen, an unsubstituted or substituted $C_1$-$C_{20}$ alkyl group, an unsubstituted or substituted $C_6$-$C_{30}$ aryl group or an unsubstituted or substituted $C_3$-$C_{30}$ hetero aryl group; and
each of $L^1$ and $L^2$ is independently a single bond, an unsubstituted or substituted $C_6$-$C_{30}$ arylene group or an unsubstituted or substituted $C_3$-$C_{30}$ hetero arylene group,

[Chemical Formula 3]

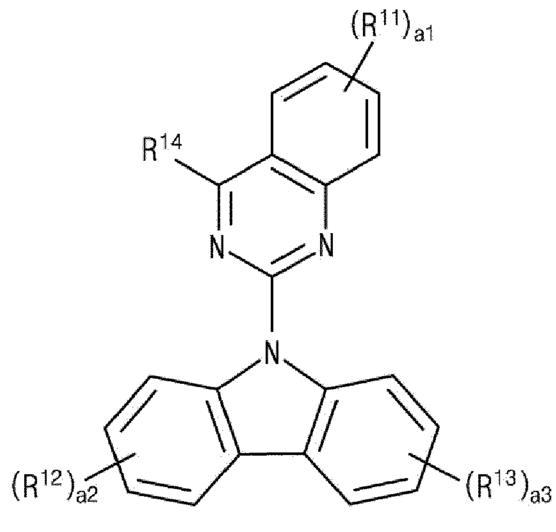

wherein, in Chemical Formula 3,
$R^{11}$ is an unsubstituted or substituted $C_6$-$C_{30}$ aryl group or an unsubstituted or substituted $C_3$-$C_{30}$ hetero

aryl group, where each $R^{11}$ is identical to or different from each other when a1 is 2, 3 or 4;
each of $R^{12}$ and $R^{13}$ is independently an unsubstituted or substituted $C_6$-$C_{30}$ aryl group or an unsubstituted or substituted $C_3$-$C_{30}$ hetero aryl group, where each $R^{12}$ is identical to or different from each other when a2 is 2, 3 or 4, each $R^{13}$ is identical to or different from each other when a3 is 2, 3 or 4, and where at least one of $R^{12}$ and $R^{13}$ is an unsubstituted or substituted $C_{10}$-$C_{30}$ fused hetero aryl group, or
optionally,
two adjacent $R^{12}$ when a2 is 2, 3 or 4, and/or
two adjacent $R^{13}$ when a3 is 2, 3 or 4
can be further linked together to form an unsubstituted or substituted $C_6$-$C_{10}$ aromatic ring;
$R^{14}$ is hydrogen, an unsubstituted or substituted $C_1$-$C_{20}$ alkyl group, an unsubstituted or substituted $C_6$-$C_{30}$ aryl group or an unsubstituted or substituted $C_3$-$C_{30}$ hetero aryl group; and
Each of a1, a2 and a3 is independently 0, 1, 2, 3 or 4, where at least one of a1, a2 and a3 is not 0.

**8.** The organic light emitting diode of claim 7, wherein a highest occupied molecular orbital energy (HOMO) energy level of the first host and a HOMO energy level of the second host satisfy the following relationship in Equation (1):

$$-0.5\ \text{eV} \leq \text{HOMO}^{H1} - \text{HOMO}^{H2} < 0\ \text{eV} \qquad (1)$$

wherein, in Equation (1), $\text{HOMO}^{H1}$ indicates a HOMO energy level of the first host and $\text{HOMO}^{H2}$ indicates a HOMO energy level of the second host.

**9.** The organic light emitting diode of claim 8, wherein the HOMO energy level of the first host and the HOMO energy level of the second host satisfy the following relationship in Equation (2):

$$-0.5\ \text{eV} \leq \text{HOMO}^{H1} - \text{HOMO}^{H2} \leq -0.3\ \text{eV} \qquad (2)$$

wherein, in Equation (2), $\text{HOMO}^{H1}$ indicates a HOMO energy level of the first host and $\text{HOMO}^{H2}$ indicates a HOMO energy level of the second host.

**10.** The organic light emitting diode of any one of claims 7 to 9, wherein the second host is at least one of the following organic compounds:

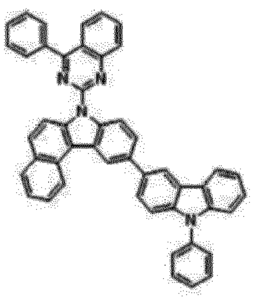
RH1

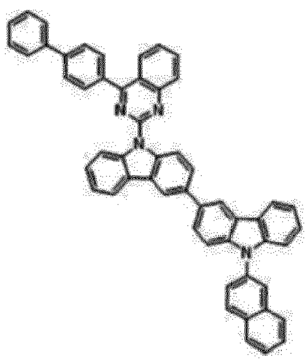
RH2

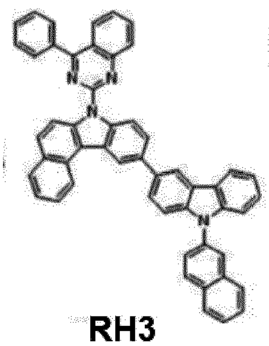
RH3

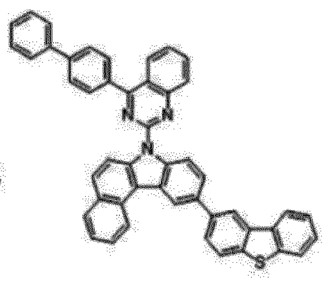
RH4

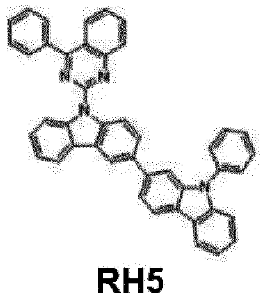
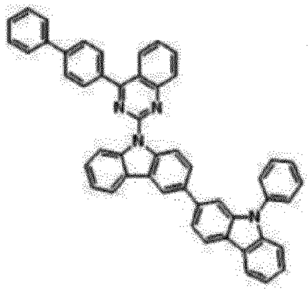
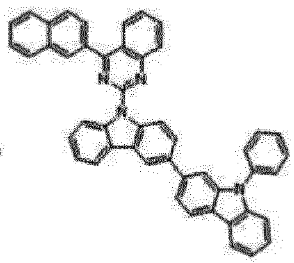
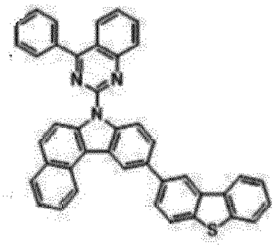

RH5 RH6 RH7 RH8

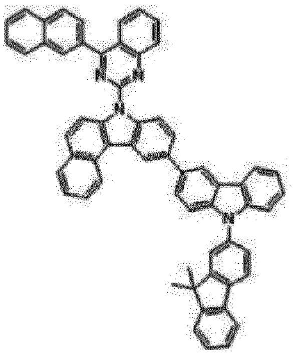
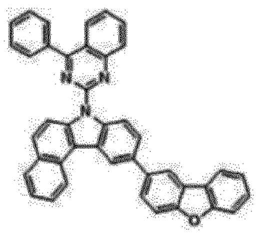
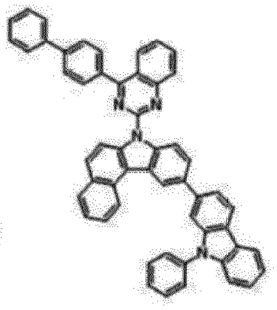
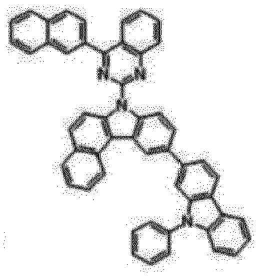

RH9 RH10 RH11 RH12

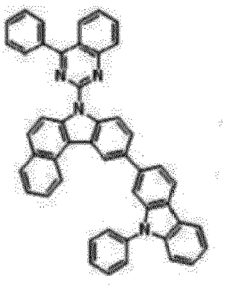
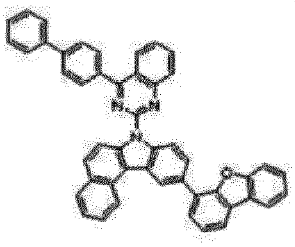
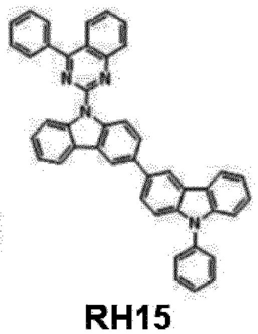
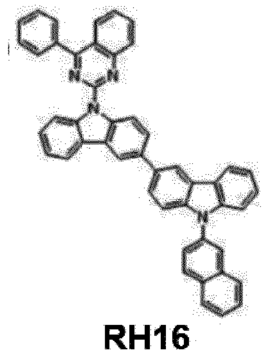

RH13 RH14 RH15 RH16

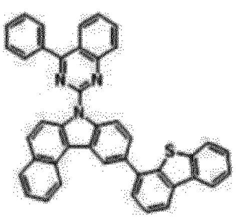
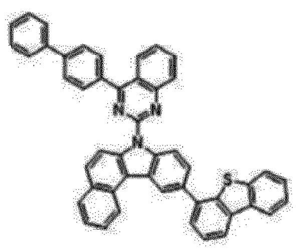
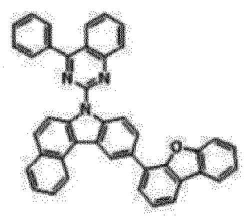
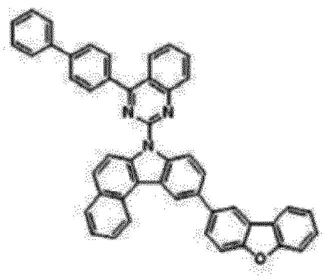

RH17 RH18 RH19 RH20

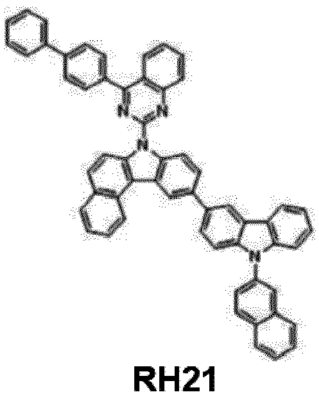

RH21

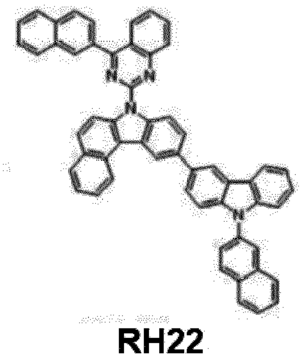

RH22

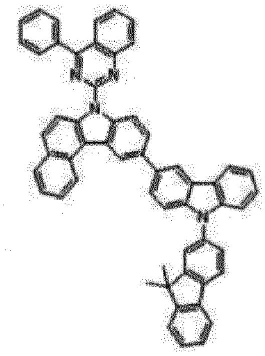

RH23

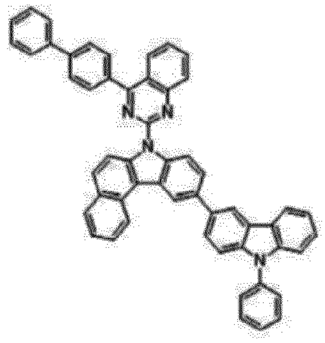

RH24

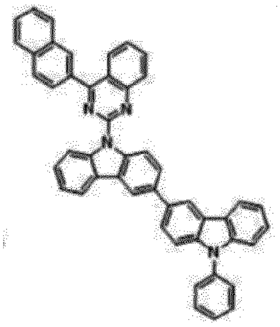

RH25

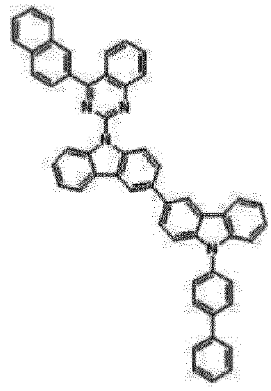

RH26

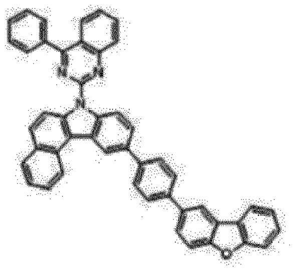

RH27

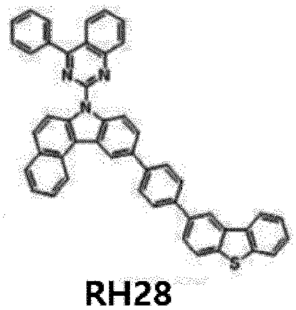

RH28

.

**11.** The organic light emitting diode of any one of claims 7 to 10, wherein the emissive layer comprises:

a first emitting part disposed between the first electrode and the second electrode;
a second emitting part disposed between the first emitting part and the second electrode;
a third emitting part disposed between the second emitting part and the second electrode;
a fourth emitting part disposed between the third emitting part and the second electrode;
a first charge generation layer disposed between the first emitting part and the second emitting part;
a second charge generation layer disposed between the second emitting part and the third emitting part; and
a third charge generation layer disposed between the third emitting part and the fourth emitting part, and

wherein one of the first emitting part, the second emitting part, the third emitting part and the fourth emitting part comprises the blue emitting material layer and the red emitting material layer.

**12.** The organic light emitting diode of claim 11, wherein the first emitting part comprises the blue emitting material layer and the red emitting material layer.

**13.** An organic light emitting diode, comprising:

a first electrode;
a second electrode facing the first electrode; and
an emissive layer disposed between the first and second electrode, and comprising at least one emitting material layer,
wherein each of the at least one emitting material layer comprises:

a blue emitting material layer comprising a first host; and
a red emitting material layer disposed between the blue emitting material layer and the second electrode, and comprising a second host,

wherein the first host comprises an organic compound having the following structure of Chemical Formula 1:

[Chemical Formula 1]

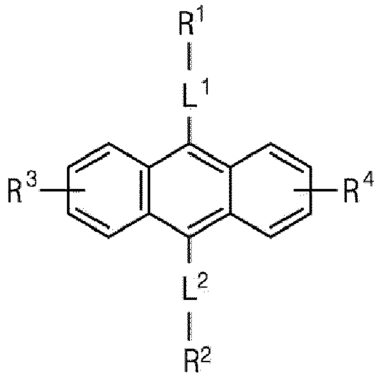

wherein, in Chemical Formula 1,
each of $R^1$ and $R^2$ is independently an unsubstituted or substituted $C_6$-$C_{30}$ aryl group or an unsubstituted or substituted $C_3$-$C_{30}$ hetero aryl group;
each of $R^3$ and $R^4$ is independently hydrogen, an unsubstituted or substituted $C_1$-$C_{20}$ alkyl group, an unsubstituted or substituted $C_6$-$C_{30}$ aryl group or an unsubstituted or substituted $C_3$-$C_{30}$ hetero aryl group; and
each of $L^1$ and $L^2$ is independently a single bond, an unsubstituted or substituted $C_6$-$C_{30}$ arylene group or an unsubstituted or substituted $C_3$-$C_{30}$ hetero arylene group; and
wherein the second host comprises an organic compound having the following structure of Chemical Formula 3:

[Chemical Formula 3]

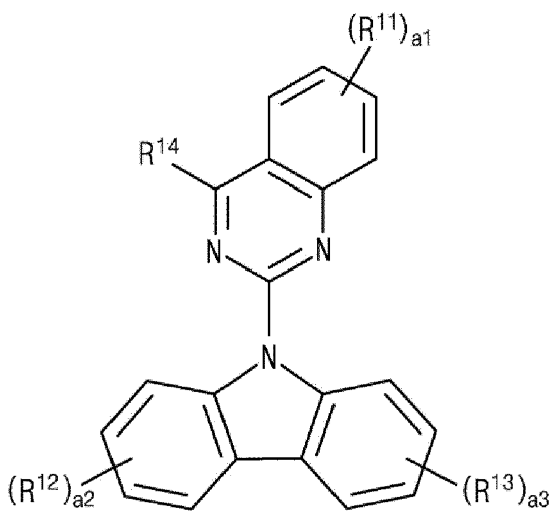

wherein, in Chemical Formula 3,

$R^{11}$ is an unsubstituted or substituted $C_6$-$C_{30}$ aryl group or an unsubstituted or substituted $C_3$-$C_{30}$ hetero aryl group, where each $R^{11}$ is identical to or different from each other when a1 is 2, 3 or 4;

each of $R^{12}$ and $R^{13}$ is independently an unsubstituted or substituted $C_6$-$C_{30}$ aryl group or an unsubstituted or substituted $C_3$-$C_{30}$ hetero aryl group, where each $R^{12}$ is identical to or different from each other when a2 is 2, 3 or 4, each $R^{13}$ is identical to or different from each other when a3 is 2, 3 or 4, and where at least one of $R^{12}$ and $R^{13}$ includes an unsubstituted or substituted $C_{10}$-$C_{30}$ fused hetero aryl group, or

optionally,

two adjacent $R^{12}$ when a2 is 2, 3 or 4, and/or

two adjacent $R^{13}$ when a3 is 2, 3 or 4

can be further linked together to form an unsubstituted or substituted $C_6$-$C_{10}$ aromatic ring;

$R^{14}$ is hydrogen, an unsubstituted or substituted $C_1$-$C_{20}$ alkyl group, an unsubstituted or substituted $C_6$-$C_{30}$ aryl group or an unsubstituted or substituted $C_3$-$C_{30}$ hetero aryl group; and

each of a1, a2 and a3 is independently 0, 1, 2, 3 or 4, where at least one of a1, a2 and a3 is not 0.

**14.** The organic light emitting diode according to claim 13, wherein the first host is selected from the group consisting of 9,10-di(naphthalen-2-yl)anthracene, 2-methyl-9,10-bis(naphthalen-2-yl)anthracene, 2-tert-Butyl-9,10-di(naphthen-2-yl)anthracene, 9,10-di(naphthalen-2-yl)-2-phenylanthracene, 9,10-di(1-naphthyl)anthracene, 9-(naphthalene-1-yl)-10-(naphthalene-2-yl)anthracene, 9-(2-napthyl)-10-[4-(1-naphthyl)phenyl]anthracene, 9-(1-napthyl)-10-[4-(2-naphthyl)phenyl]anthracene, 9-phenyl-10-(p-tolyl)anthracene, 9-(1-naphthyl)-10-(p-tolyl)anthracene, 9-(2-naphthyl)-10-(p-tolyl)anthracene, 2-(3-(10-phenylanthracen-9-yl)-phenyl)dibenzo[b,d]furan, 2-(4-(10-phenylanthracen-9-yl)phenyl)dibenzo[b,d]furan and combinations thereof; and
the second host is at least one of the following organic compounds:

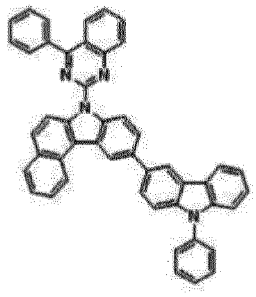

RH1

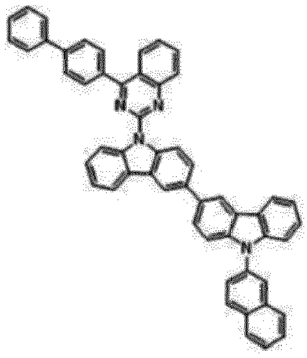

RH2

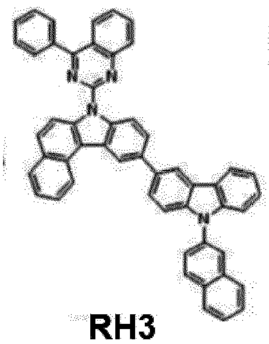

RH3

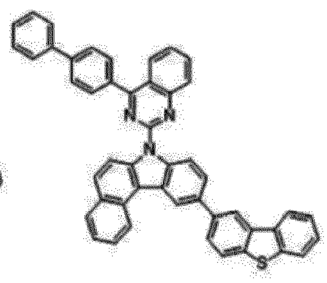

RH4

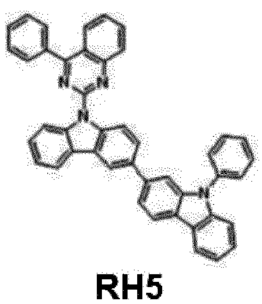

RH5

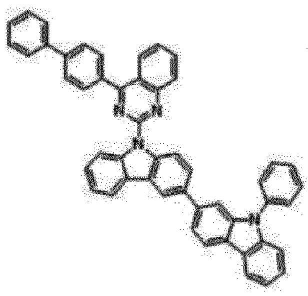

RH6

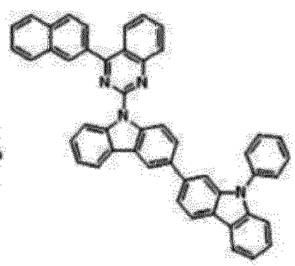

RH7

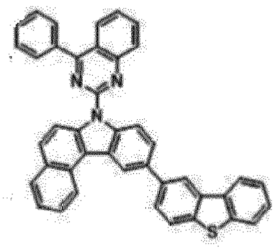

RH8

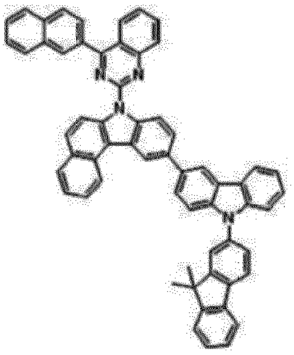

RH9

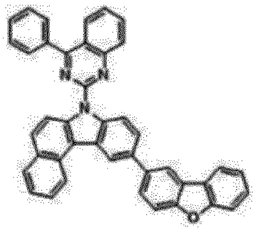

RH10

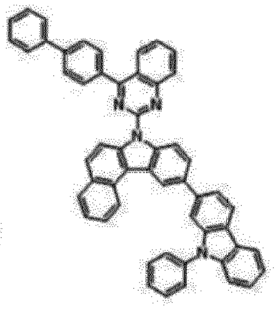

RH11

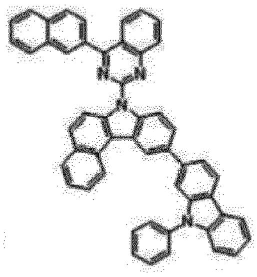

RH12

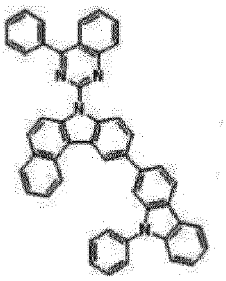

RH13

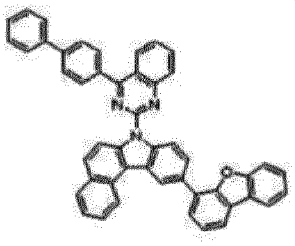

RH14

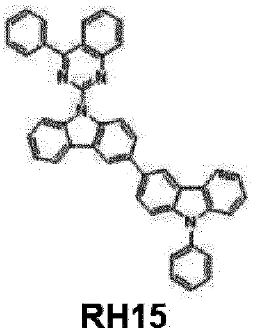

RH15

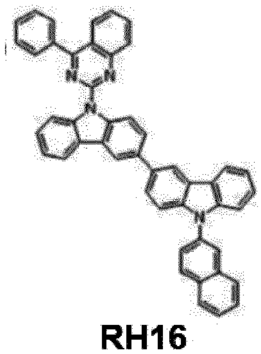

RH16

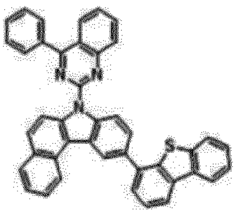

RH17

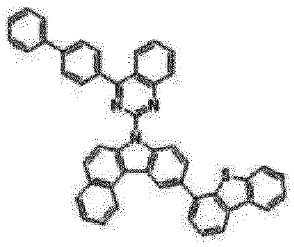

RH18

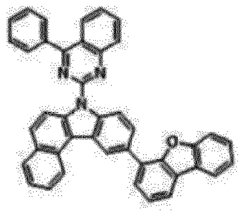

RH19

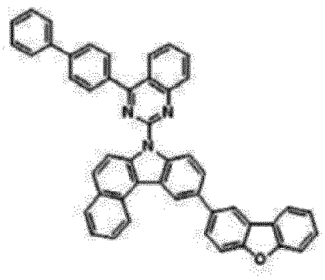

RH20

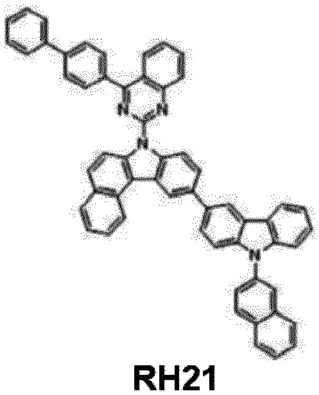

RH21

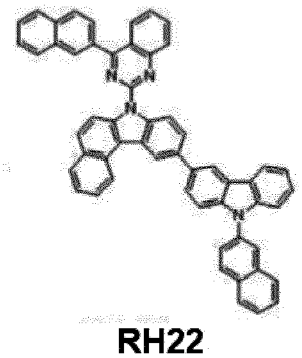

RH22

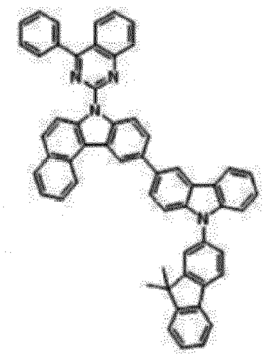

RH23

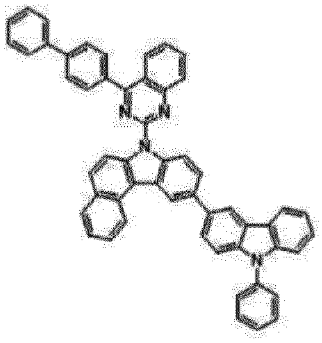

RH24

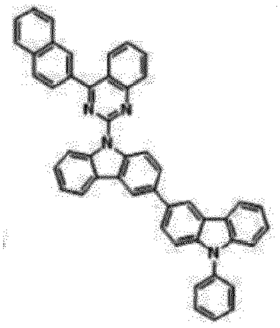

RH25

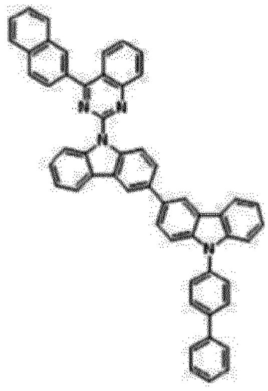

RH26

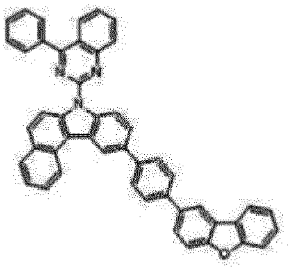

RH27

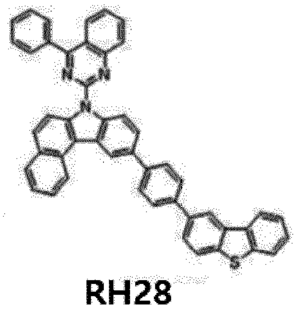

RH28

15. The organic light emitting diode of claim 13 or 14, wherein the first electrode is an anode and the second electrode is a cathode.

# FIG. 1

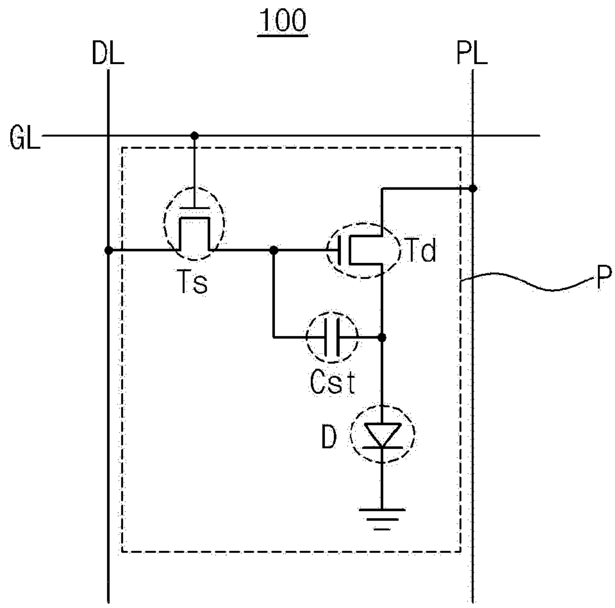

# FIG. 2

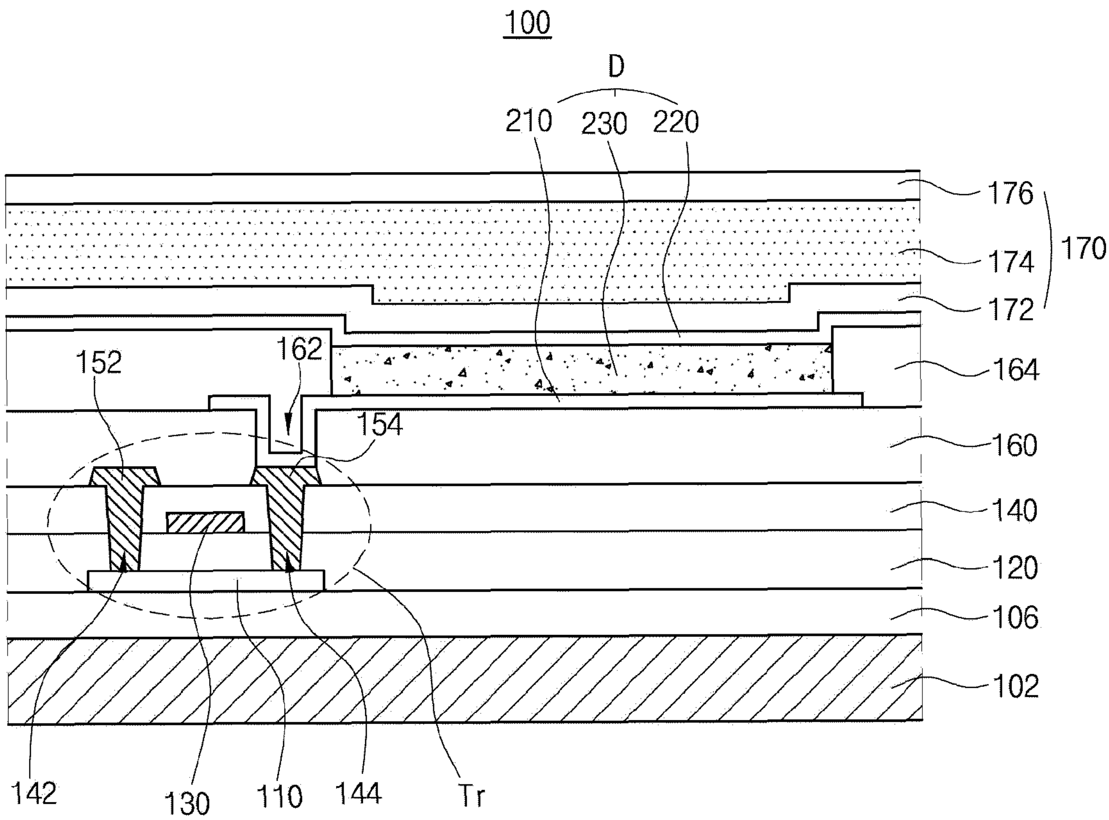
100
D
210
230
220
176
174
170
172
164
162
152
154
160
140
120
106
102
142
130
110
144
Tr

# FIG. 3

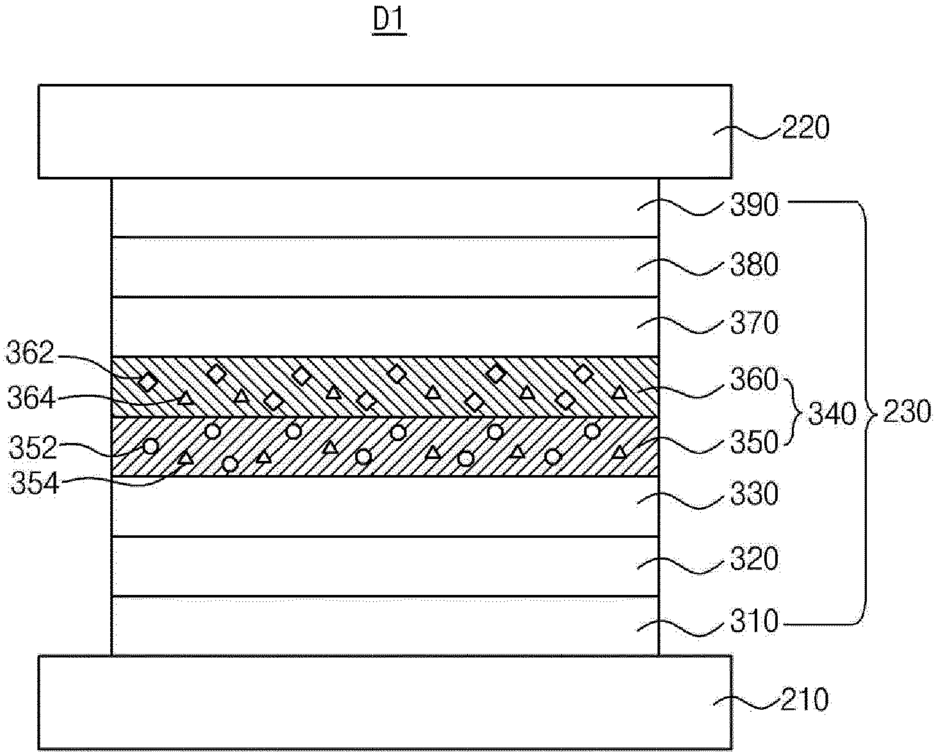
D1
220
390
380
370
362
364
360
340
230
352
354
350
330
320
310
210

# FIG. 4

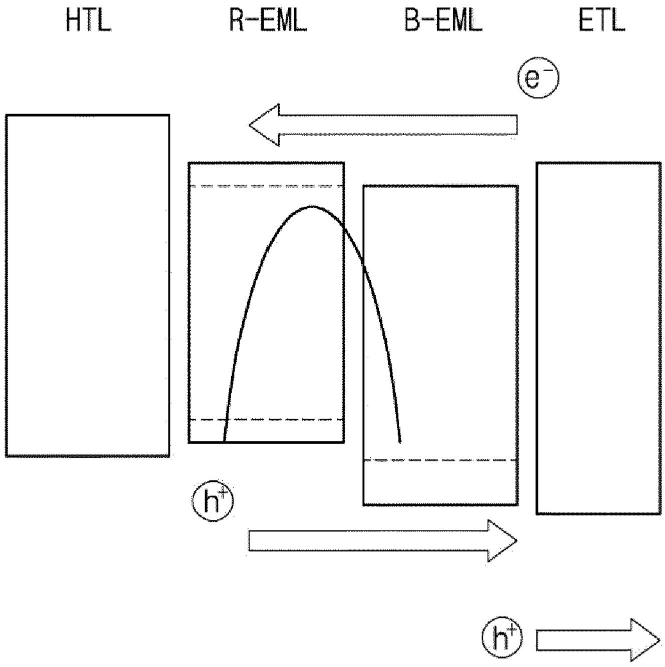


# FIG. 5

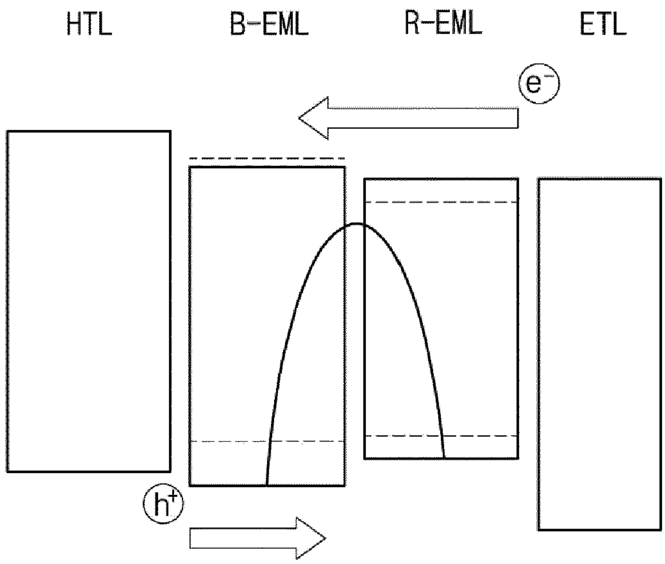

# FIG. 6

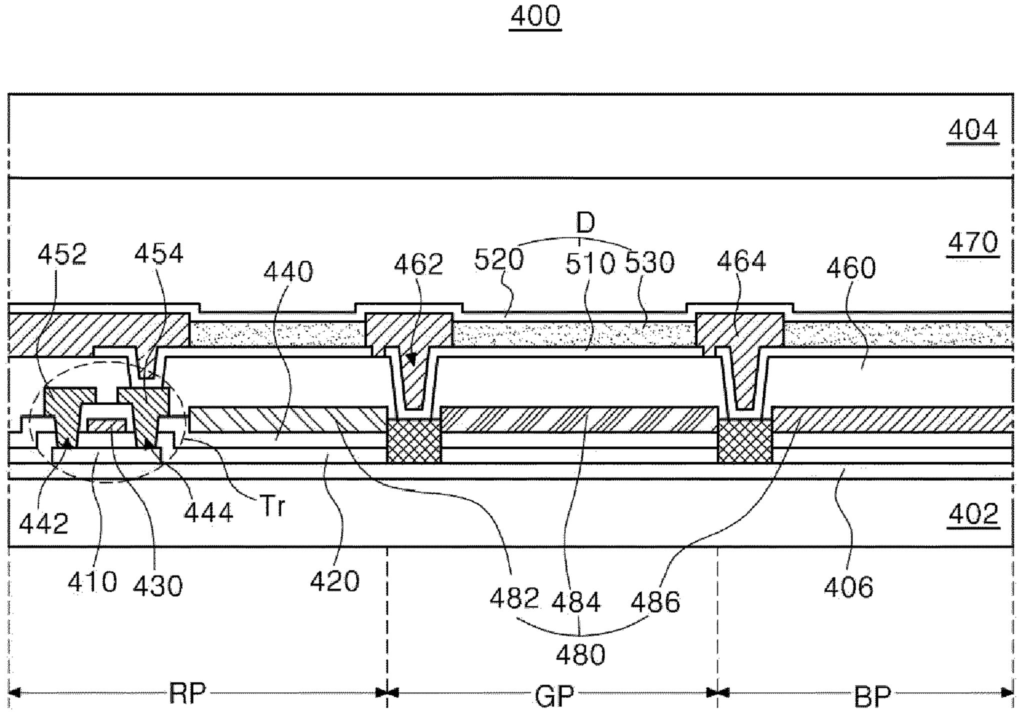
400
404
470
D
452
454
440
462
520
510
530
464
460
442
444
Tr
402
410
430
420
482
484
486
406
480
RP
GP
BP

# FIG. 7

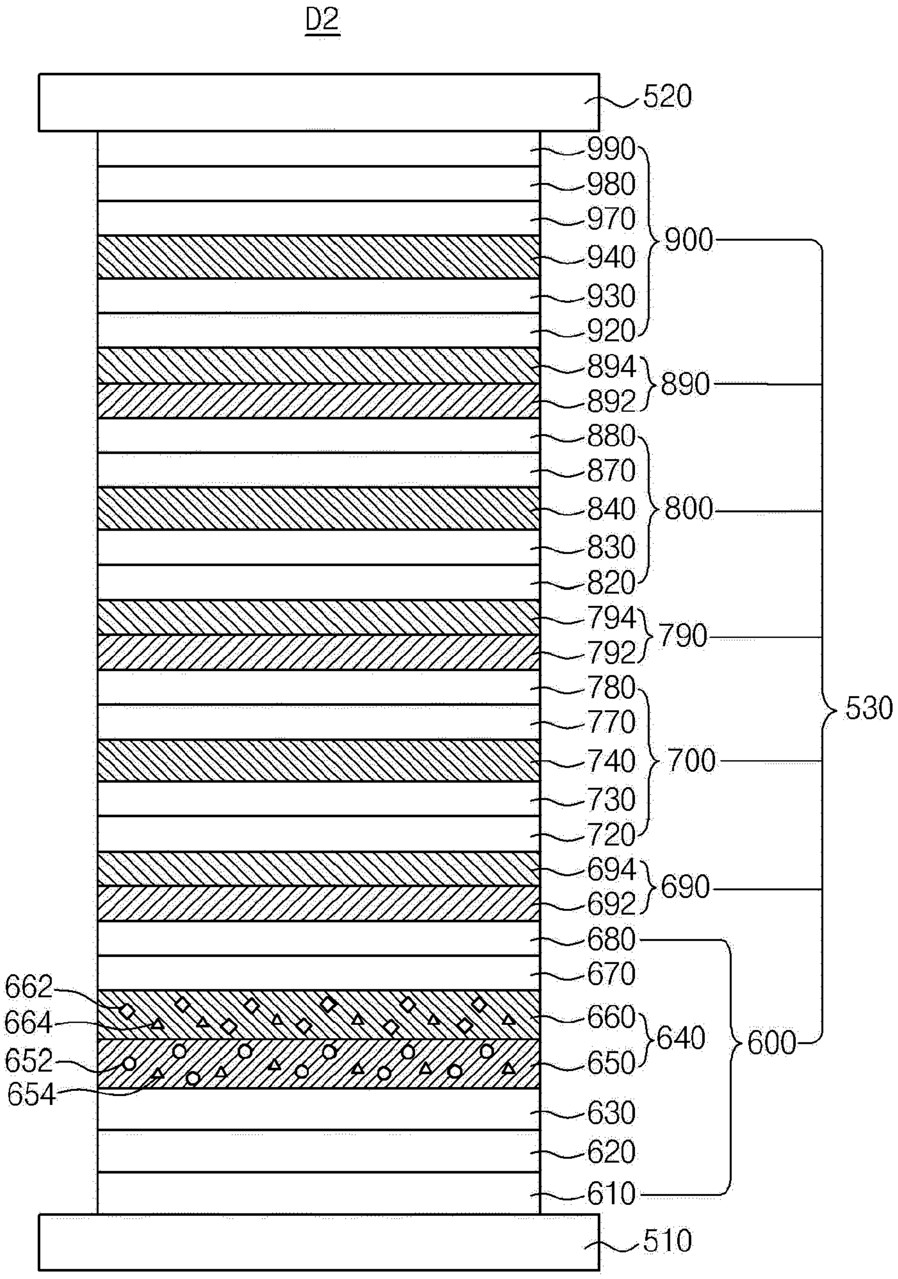
D2
520
990
980
970
940
930
920
900
894
892
890
880
870
840
830
820
800
794
792
790
780
770
740
730
720
700
530
694
692
690
680
670
662
664
660
640
652
654
650
600
630
620
610
510

# FIG. 8

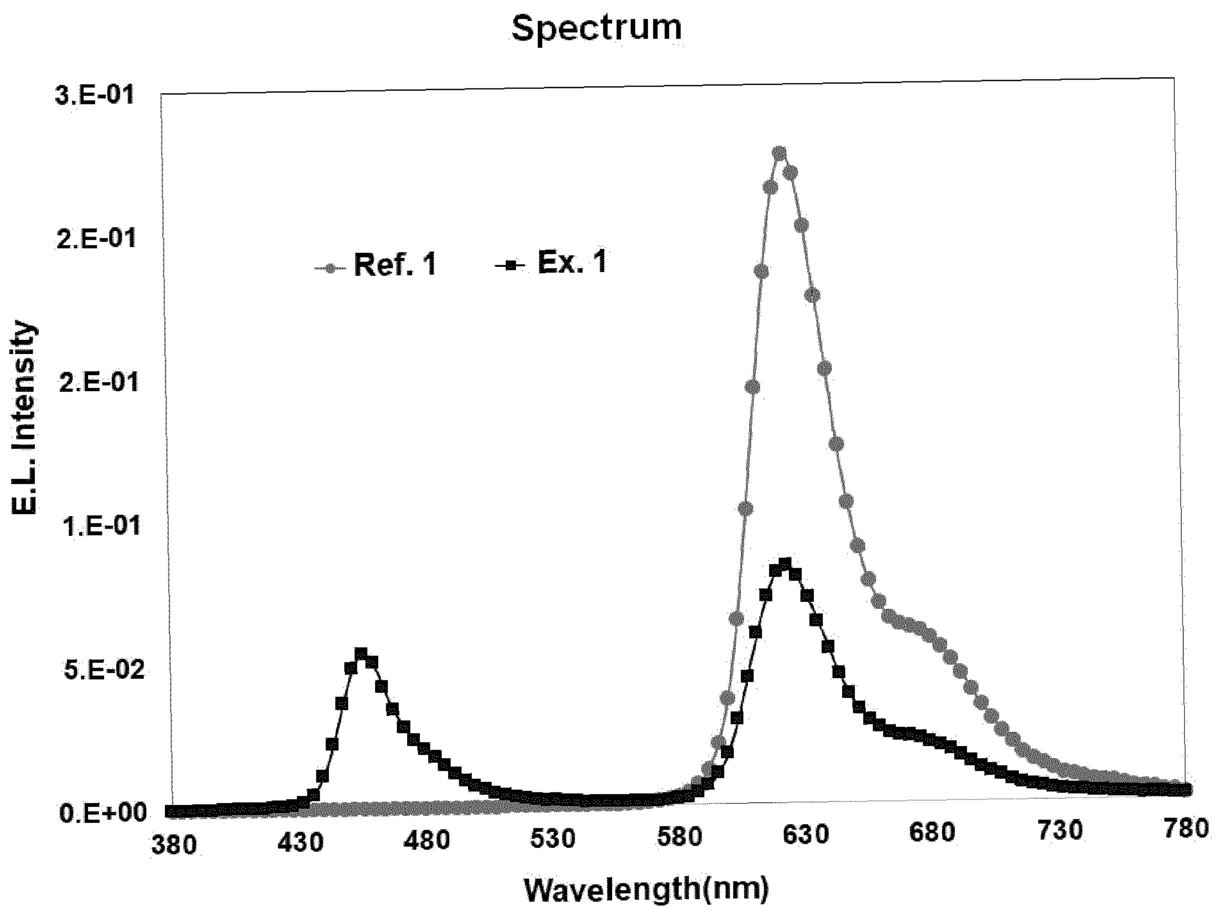
Spectrum
3.E-01
2.E-01
2.E-01
1.E-01
5.E-02
0.E+00
E.L. Intensity
Ref. 1
Ex. 1
380
430
480
530
580
630
680
730
780
Wavelength(nm)

FIG. 9

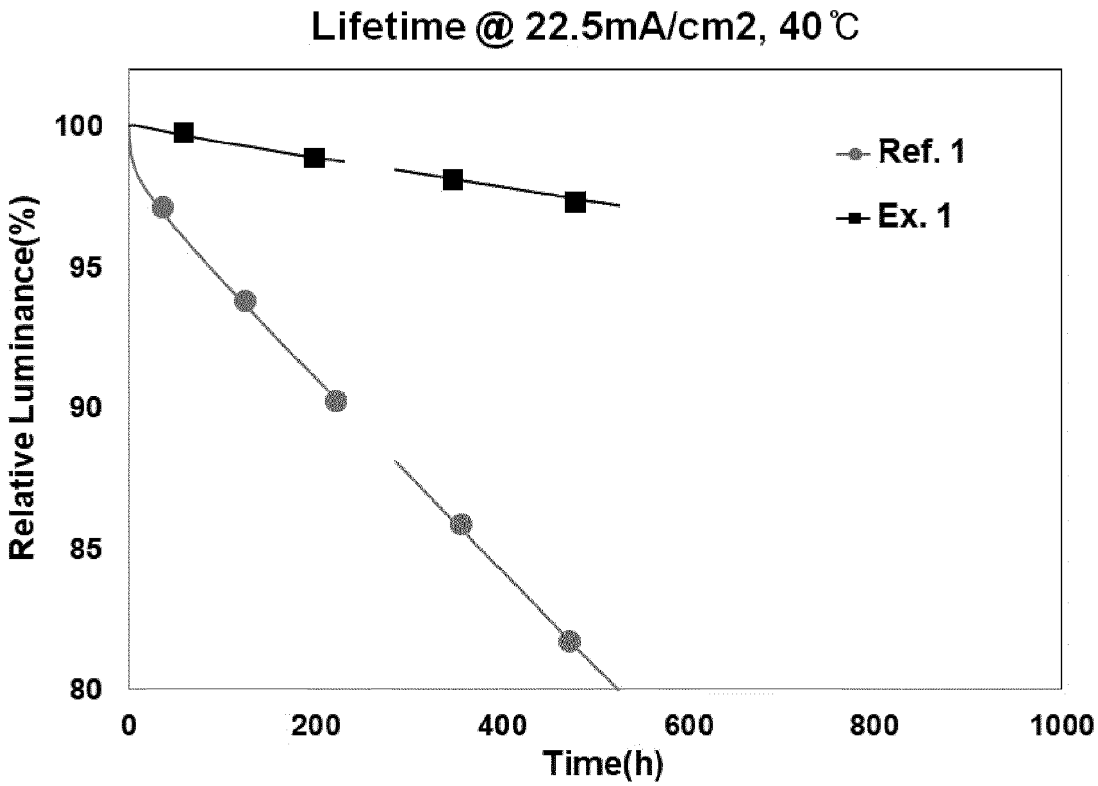
Lifetime @ 22.5mA/cm2, 40℃
Relative Luminance(%)
100
95
90
85
80
0
200
400
600
800
1000
Time(h)
Ref. 1
Ex. 1

FIG. 10

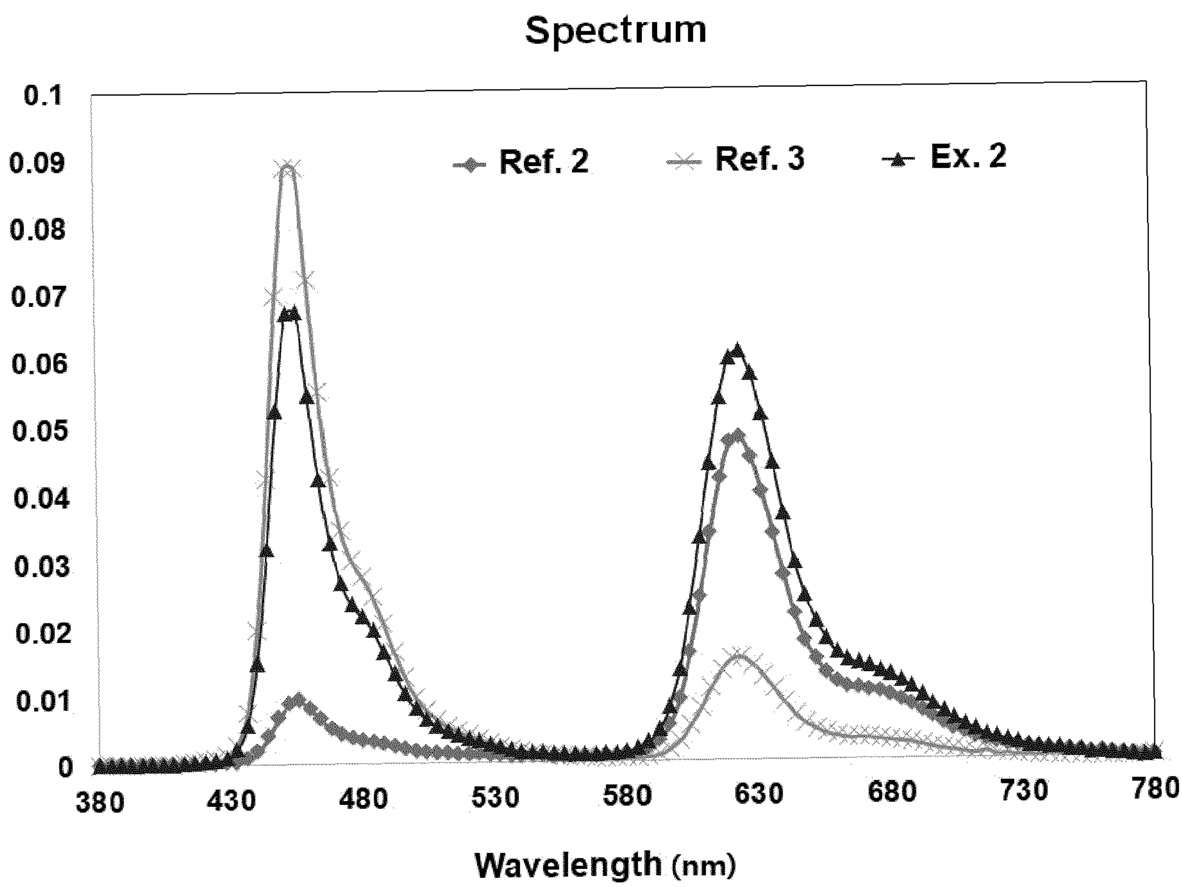
Spectrum
Ref. 2
Ref. 3
Ex. 2
0.1
0.09
0.08
0.07
0.06
0.05
0.04
0.03
0.02
0.01
0
380
430
480
530
580
630
680
730
780
Wavelength (nm)

# FIG. 11

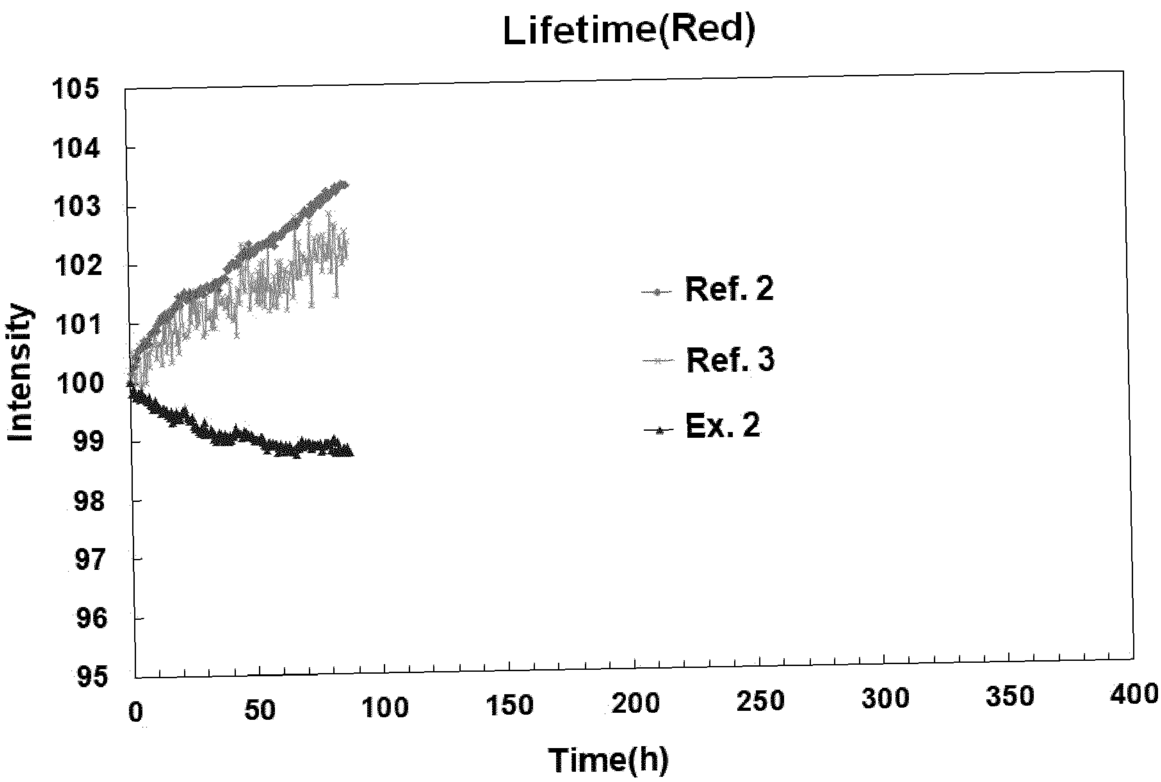
Lifetime(Red)
105
104
103
102
101
100
99
98
97
96
95
Intensity
Ref. 2
Ref. 3
Ex. 2
0
50
100
150
200
250
300
350
400
Time(h)

# FIG. 12

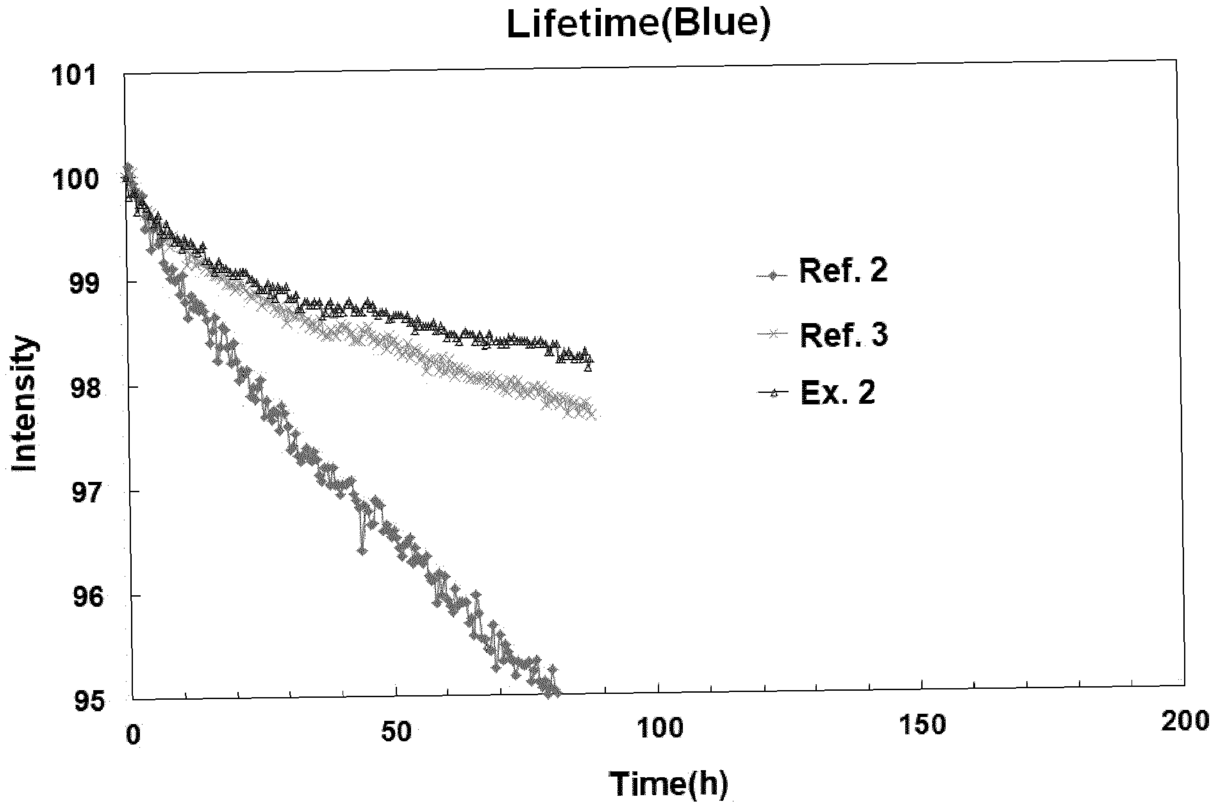
Lifetime(Blue)
Intensity
101
100
99
98
97
96
95
0
50
100
150
200
Time(h)
Ref. 2
Ref. 3
Ex. 2

Europäisches Patentamt
European Patent Office
Office européen des brevets

# EUROPEAN SEARCH REPORT

Application Number
EP 23 20 4413

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LIU BAIQUAN ET AL: "High-performance hybrid white organic light-emitting diodes employing p-type interlayers", JOURNAL OF INDUSTRIAL AND ENGINEERING CHEMISTRY, THE KOREAN SOCIETY OF INDUSTRIAL AND ENGINEERING CHEMISTRY, KOREA, vol. 27, 8 January 2015 (2015-01-08), pages 240-244, XP029611577, ISSN: 1226-086X, DOI: 10.1016/J.JIEC.2014.12.040 | 1-3,6 | INV. H10K50/13<br>ADD. H10K101/00 H10K101/30 H10K85/60 |
| A | * the whole document * | 4,5,7-15 | |
| A | WO 2012/050347 A1 (ROHM & HAAS ELECT MAT [KR]; NA HONG YOEP [KR] ET AL.) 19 April 2012 (2012-04-19) * paragraph [0120] - paragraph [0207]; claims 1-10 * | 1-15 | |
| A | CN 109 553 620 A (BEIJING ETERNAL MAT TECH CO LTD; GUAN ETERNAL MATERIAL TECH CO LTD) 2 April 2019 (2019-04-02) * paragraph [0026] - paragraph [0109]; claims 1-8 * | 1-15 | TECHNICAL FIELDS SEARCHED (IPC)<br>H10K |
| T | KROGER M ET AL: "P-type doping of organic wide band gap materials by transition metal oxides: A case-study on Molybdenum trioxide", ORGANIC ELECTRONICS, ELSEVIER, AMSTERDAM, NL, vol. 10, no. 5, 1 August 2009 (2009-08-01), pages 932-938, XP026235906, ISSN: 1566-1199, DOI: 10.1016/J.ORGEL.2009.05.007 [retrieved on 2009-05-10] | | |

-/--

The present search report has been drawn up for all claims

1

| Place of search | Date of completion of the search | Examiner |
|---|---|---|
| The Hague | 22 April 2024 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 23 20 4413

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | MARKUS GANTENBEIN ET AL: "New 4,4'-Bis(9-carbazolyl)-Biphenyl Derivatives with Locked Carbazole-Biphenyl Junctions: High-Triplet State Energy Materials", CHEMISTRY OF MATERIALS, vol. 27, no. 5, 10 March 2015 (2015-03-10), pages 1772-1779, XP055191916, ISSN: 0897-4756, DOI: 10.1021/cm5045754 ----- | | |
| T | TING ZHANG ET AL: "A CBP derivative as bipolar host for performance enhancement in phosphorescent organic light-emitting diodes", JOURNAL OF MATERIALS CHEMISTRY C, vol. 1, no. 4, 1 January 2013 (2013-01-01), pages 757-764, XP055191881, ISSN: 2050-7526, DOI: 10.1039/C2TC00305H ----- | | |
| T | JUNG-HWAN PARK ET AL: "New Bipolar Green Host Materials Containing Benzimidazole-Carbazole Moiety in Phosphorescent OLEDs", BULLETIN OF THE KOREAN CHEMICAL SOCIETY, vol. 32, no. 3, 20 March 2011 (2011-03-20), pages 841-846, XP055191890, ISSN: 0253-2964, DOI: 10.5012/bkcs.2011.32.3.841 ----- | | TECHNICAL FIELDS SEARCHED (IPC) |
| T | NAMDAS EBINAZAR ET AL: "Simple color tuning of phosphorescent dendrimer light emitting diodes", APPLIED PHYSICS LETTERS, AMERICAN INSTITUTE OF PHYSICS, 2 HUNTINGTON QUADRANGLE, MELVILLE, NY 11747, vol. 86, no. 16, 11 April 2005 (2005-04-11), pages 161104-161104, XP012065079, ISSN: 0003-6951, DOI: 10.1063/1.1899256 ----- | | |

1

The present search report has been drawn up for all claims

| Place of search | Date of completion of the search | Examiner |
|---|---|---|
| The Hague | 22 April 2024 | Konrádsson, Ásgeir |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT ON EUROPEAN PATENT APPLICATION NO. EP 23 20 4413

This annex lists the patent family members relating to the patent documents cited in the above-mentioned European search report. The members are as contained in the European Patent Office EDP file on
The European Patent Office is in no way liable for these particulars which are merely given for the purpose of information.

22-04-2024

| Patent document cited in search report | Publication date | Patent family member(s) | Publication date |
|---|---|---|---|
| WO 2012050347 A1 | 19-04-2012 | CN 103249800 A | 14-08-2013 |
| | | JP 2013546171 A | 26-12-2013 |
| | | KR 20120038060 A | 23-04-2012 |
| | | TW 201226398 A | 01-07-2012 |
| | | WO 2012050347 A1 | 19-04-2012 |
| CN 109553620 A | 02-04-2019 | NONE | |

EPO FORM P0459

For more details about this annex : see Official Journal of the European Patent Office, No. 12/82